(19) **Europäisches Patentamt / European Patent Office / Office européen des brevets**

(11) **EP 1 876 387 A1**

(12) **EUROPEAN PATENT APPLICATION**
published in accordance with Art. 153(4) EPC

(43) Date of publication:
09.01.2008 Bulletin 2008/02

(51) Int Cl.:
*F21V 3/04* (2006.01)    *F21S 2/00* (2006.01)
*F21S 8/04* (2006.01)    *F21V 5/04* (2006.01)
*F21V 9/08* (2006.01)    *F21Y 101/02* (2006.01)

(21) Application number: 06714042.6

(22) Date of filing: 13.02.2006

(86) International application number:
PCT/JP2006/302901

(87) International publication number:
WO 2006/085693 (17.08.2006 Gazette 2006/33)

(84) Designated Contracting States:
DE

(30) Priority: 14.02.2005 JP 2005036688

(71) Applicant: Mitsubishi Chemical Corporation
Minato-ku
Tokyo 108-0014 (JP)

(72) Inventors:
• UCHIDA, Yuji
Yamaguchi 7550075 (JP)

• TAGUCHI, Tsunemasa
Fukuoka-shi, Fukuoka, 8140001 (JP)
• KIJIMA, Naoto
c/o Mitsubishi Chemical Group Scienc
Kamoshida-cho, Aoba-ku, Yokohama-shi (JP)

(74) Representative: HOFFMANN EITLE
Patent- und Rechtsanwälte
Arabellastrasse 4
81925 München (DE)

(54) **LIGHT SOURCE, SOLID STATE LIGHT EMITTING ELEMENT MODULE, FLUORESCENT MODULE, LIGHT ORIENTATION ELEMENT MODULE, ILLUMINATION DEVICE, IMAGE DISPLAY DEVICE, AND LIGHT SOURCE ADJUSTMENT METHOD**

(57) An object of the present invention is to make possible irradiating a desired irradiated surface with a homogenized-colored light having high color rendering, with high luminous efficiency. To achieve the object, the present invention provides a light source comprising two or more primary light sources, each of which emits primary light having different wavelength, wherein the maximum value among differences between each of CIE chromaticity coordinates of the primary lights is 0.05 or larger, the primary lights have the same illuminance distribution characteristics at a desired irradiated surface, the luminous efficiency is 30 lm/W or larger, and the general color rendering index is 60 or larger.

FIG. 4

**Description**

Technical Field

The present invention relates to a light source, light-emitting solid device module, phosphor module, Illuminance-distribution element module, and a lighting system and display using them, and also relates to a method for controlling light emitted from a light source.

Background Art

Conventionally, a fluorescent lamp has been mainly used as light source for a lighting system. A fluorescent lamp is constructed by enclosing evaporated mercury within a glass tube and attaching two or more kinds of phosphors to the inner wall of the glass tube with attachment agent. Using low-pressure arc discharge for the evaporated mercury generates plasma of mercury ions and electrons. This energy exchange makes electrons of mercury atoms excite, thereby ultraviolet or visible light is emitted while the electrons move back toward the ground state. At this time, the phosphor is excited by the ultraviolet from the mercury atoms and emits fluorescence, which is then synthesized with the visible light emitted from the mercury, thereby the fluorescent lamp emitting white light finally (Non-Patent Document 1 and 2).

It has been also proposed to use a light emitting diode (hereinafter referred to as "LED" as appropriate) as lighting system. An LED is constructed to emit light by passing an electric current through a junction of p-type semiconductor and n-type semiconductor to induce recombination between holes and electrons.

But in recent years, as an alternative light source, a synthetic light source has been developed, in which an LED is combined with a phosphor which absorbs light from the LED and emits fluorescence (refer to Patent Document 1). This type of synthetic light source mixes lights emitted from a light emitting diode, phosphor and the like and emits the synthesized light.

As an concrete example of the above synthetic light source can be cited a synthetic light source in which a blue-light emitting LED (Blue-LED) and a phosphor of $(Y,Gd)_3(Al,Ga)_5O_{12}$:Ce (hereinafter referred to as "YAG:Ce" as appropriate) are integrated. In this synthetic light source, the InGaN:Blue-LED excites the YAG : Ce phosphor and blue transmitted light emitted from the InGaN:Blue-LED and yellow fluorescence emitted from the YAG:Ce phosphor are mixed, to thereby synthesize white color composed of complementary colors.

As another example of the above synthetic light source can be cited a synthetic light source in which a near-ultraviolet emitting LED (near-UV LED) and phosphors emitting red, green and blue fluorescence respectively are combined. Still another example of the synthetic light source is a synthetic light source in which a near-UV LED and phosphors emitting orange, yellow, green and blue fluorescence respectively are combined. In these synthetic light sources, the near-UV LED excites each of the phosphors and fluorescence emitted from the respective phosphors is mixed, to thereby synthesize white color (Non-Patent Document 3 and 4).

It has also been proposed to use a plasma display panel (hereinafter referred to as "PDP" as appropriate) for a lighting system.

In addition, a light source as described above may be used as a display (Non-Patent Document 5 and 6).

As an example of that kind of display can be cited a display using a CRT (Cathode-Ray Tube). This is constructed so that phosphors coated on the surface of a cathode-ray tube are excited and emit light two-dimensionally by being radiated with electron beam, thereby an image being displayed.

As another example can be cited a display using a PDP. This is constructed so that Ne-Xe or He-Xe gas, enclosed into a minute section partitioned two-dimensionally, is excited by plasma discharge and emits ultraviolet having a predetermined wavelength, by which phosphors coated two-dimensionally and each capable of emitting red, green and blue fluorescence are excited and emit light, thereby an image being displayed.

As still another example can be cited a display using an inorganic EL (Electro Luminescence) element. This is constructed to form a two-dimensionally arranged, laminated structure of inorganic semiconductors that can emit red, green and blue light so as to emit light by applying voltage on the element using the above semiconductor to induce recombination between holes and electrons, thereby an image being displayed.

As still another example can be cited a display using an OEL (Organic Electro Luminescence) or OLED (Organic Light Emitting Diode). This is constructed to form a two-dimensionally arranged, laminated structure of organic semiconductors that can emit red, green and blue light so as to emit light by applying voltage on the element using the above semiconductor to induce recombination between holes and electrons, thereby an image being displayed.

As still another example can be also cited a display using an LED. This is constructed to form a two-dimensionally arranged structure of LEDs that can emit red, green and blue light so as to emit light by passing an electric current through the element having these LEDs to induce recombination between holes and electrons, thereby an image being displayed.

Incidentally, in the light source as mentioned above, the color and the amount of light emitted from the light source is often controlled. Therefore, various methods for controlling light, emitted from the light source, have been developed conventionally (Non-Patent Document 5, 7 and 8).

As an example of a method for controlling light of a fluorescent lamp, the amount of light is being controlled by adjusting the power of discharge voltage using PWM voltage with the aid of a pulse-width modulation (hereinafter referred to as "PWM" as appropriate) circuit. This enables the light amount of a fluorescent lamp to be controlled at the lighting system level. However, this can not make the color temperature changeable.

As another example, the color temperature and the light amount of a filament lamp can be controlled by making the applied voltage changeable with the aid of a variable resistance.

In addition, also in light sources such as fluorescent lamp, CRT, PDP, EL, OEL, OLED and LED, the amount of light is controlled by adjusting the PWM voltage with the aid of a PWM circuit.

[Patent Document 1] Japanese Patent Laid-Open Application No. 2004-71726

[Non-Patent Document 1] "Lighting handbook (2nd Edition)", The Illuminating Institute of Japan, pp. 73 to 80, 102 to 116

[Non-Patent Document 2] "Lighting handbook (2nd Edition)", The Illuminating Institute of Japan, pp. 126 to 129

[Non-Patent Document 3] "Technology for High-Brightness, High-Efficiency, and Prolonged-Life White-Light LED Lighting Systems" Under the Editorship of Tsunemasa Taguchi, Technical Information Institute Co., Ltd., pp. 90 to 93

[Non-Patent Document 4] "Present Status of White Lighting Technologies in Japan", T.Taguchi: J.Light & Vis. Env., Vol. 27, No.3, pp. 131 to 139, 2003

[Non-Patent Document 5] "NHK Color TV Textbook Vol. 1, 2)", Japan Broadcasting Corporation

[Non-Patent Document 6] "All about Plasma Display TV", Heiju Uchiike, Shigeo Mikoshiba, Industrial Investigation Committees

[Non-Patent Document 7] "Lighting handbook (2nd Edition)", The Illuminating Institute of Japan, pp. 139 to 144

[Non-Patent Document 8] "Basis of Pulse and Digital Circuit", Norio Kojima, Modern Engineering

Disclosure of the Invention

[Problem to Be Solved by the Invention]

In recent years, various new light sources utilizing an LED or synthetic light source like above have been developed for the porpose of such as improving the brightness of the light emitted. Among those, the following technique of a light source which utilizes multipoint emitting has been studied. In the technique, two or more of light sources (hereinafter, referred to as "primary light sources", as appropriate) emitting lights of different colors are used to emit lights (hereinafter, referred to as "primary lights", as appropriate), and those primary lights are synthesized to be a synthesized light, with which a desired surface (hereinafter, referred to as "irradiated surface", as appropriate) is irradiated.

However, in the above light source utilizing multipoint emitting, it is difficult to synthesize a homogenized primary lights, which constitute the synthesized light, and irradiate the irradiated surface with a light of homogenized color, frequently leading to the problem of strained color at the irradiated surface.

There is also room for improvement, in the conventional light source utilizing multipoint emitting, of color rendering of the synthesized light, with which the irradiated surface is irradiated.

In addition, each component of a light source is usually different in lifetime. For example, in a synthetic light source combining an LED with a phosphor, the LED and phosphor are different in lifetime. Particularly, a phosphor often comes to the end of lifetime earlier than LED by deterioration due to the heat from the LED which serves as light source for excitation. However, when a component having short lifetime comes to be unworkable, the entire light source has been replaced conventionally. This results in a problem of increase in running cost.

Further, conventionally, it has been difficult to control the color temperature of the light emitted from the light source, other than a filament lamp light source. However, a filament lamp may fuse at its light emitting portion due to excessive high temperature while emitting light. Therefore, a technology has been desired to be developed wherein the color temperature of the light emitted can be controlled in the light source itself, without replacing the light source itself or using a filament lamp as light source.

In addition, the capabilities mentioned above are desired in fields of equipment utilizing light source, such as lighting system and display. Therefore, a lighting system and display having capabilities mentioned above have been also desired to be developed.

The present invention has been made in view of such problems. Accordingly, the first object of the present invention is to provide a light source that can irradiate a desired irradiated surface with a homogenized-colored light having high color rendering with high luminous efficiency, as well as a light-emitting solid device module, phosphor module and illuminance-distribution element module for constituting the light source. The second object of the present invention is to provide a light source and a method for controlling light of a light source wherein the color temperature of the light emitted can be controlled. The third object of the present invention is to provide a lighting system and display using the above-mentioned light source.

[Means for Solving the Problem]

The present inventors have found that the synthesized light can be homogenized at a desired irradiated surface by making the maximum value among differences between CIE chromaticity coordinates of the primary lights emitted from the primary light sources be a predetermined value or larger and by homogenizing the illuminance distribution characteristics of the primary lights, and that the color temperature of the synthesized light can be controlled by controlling the intensity of each primary lights keeping the above conditions satisfied, in a light source comprising two or more primary light sources, each of which emits primary light having different wavelength, for emitting synthesized light synthesized from the primary lights. These findings led to the completion of the present invention.

Namely, the subject matter of the present invention lies in a light source comprising two or more primary light sources, each of which emits primary light having different wavelength, for emitting synthesized light which is synthesized from the primary lights emitted from said primary light sources, wherein the maximum value among differences between each of CIE chromaticity coordinates of the primary lights is 0.05 or larger, the primary lights have the same illuminance distribution characteristics to the extent that the color of the synthesized light is homogenized at a desired irradiated surface, the luminous efficiency is 30 lm/W or larger, and the general color rendering index is 60 or larger (claim 1).

It is preferable that each of said two or more primary light sources comprises a light-emitting solid device emitting light having different wavelength from each other (claim 2).

It is also preferable that at least one of said two or more primary light sources comprises a light-emitting solid device and a phosphor section including a phosphor absorbing light from the light-emitting solid device and emitting light (claim 3).

It is also preferable that a spread angle of the primary lights emitted from said primary light sources is between 5° and 180° inclusive (claim 4).

It is also preferable that each of said primary light sources comprises an illuminance distribution controlling element (claim 5).

It is also preferable that the illuminance distribution controlling element has the capability of collecting the primary lights (claim 6).

It is also preferable that, in the light source of the present invention, the color of the synthesized light is white, when observed from a distance of at least 2.5 m (claim 7).

Another subject matter of the present invention lies in a light-emitting solid device module for constituting said light source described above, comprising: a base; and the light-emitting solid device disposed on said base (claim 8).

Still another subject matter of the present invention lies in a phosphor module for constituting said light source described above, comprising: a base; and the phosphor section disposed on said base (claim 9).

Still another subject matter of the present invention lies in an illuminance-distribution element module for constituting said light source described above, comprising: a base; and the illuminance-distribution controlling element disposed on said base (claim 10).

Still another subject matter of the present invention lies in a light source comprising two or more primary light sources, each of which emits primary light having different wavelength, for emitting synthesized light which is synthesized from the primary lights emitted from said primary light sources, wherein the maximum value among differences between each of CIE chromaticity coordinates of the primary lights is 0.05 or larger, and the primary lights have the same illuminance distribution characteristics to the extent that the color of the synthesized light is homogenized at a desired irradiated surface, and said light source further comprising: a primary-light controller capable of controlling at least a part of the amount of the primary lights by controlling said primary light sources (claim 11).

At this point, it is preferable that at least one of said primary light sources comprises a light-emitting solid device, and the primary-light controller controls the amount of light emitted from the light-emitting solid device (claim 12).

Still another subject matter of the present invention lies in a lighting system comprising a light source described above (claim 13).

Still another subject matter of the present invention lies in a display comprising a light source described above (claim 14).

Still another subject matter of the present invention lies in a method for controlling light emitted from a light source comprising two or more primary light sources, each of which emits primary light having different wavelength, for emitting synthesized light which is synthesized from the primary lights emitted from said primary light sources, comprising the step of: replacing said primary light source in a manner that the maximum value among differences between each of CIE chromaticity coordinates of the primary lights is kept to be 0.05 or larger and the primary lights are kept to have the same illuminance distribution characteristics to the extent that the color of the synthesized light is homogenized at a desired irradiated surface (claim 15).

Still another subject matter of the present invention lies in a method for controlling light emitted from a light source comprising two or more primary light sources, each of which comprises light-emitting solid device and emits primary light having different wavelength, for emitting synthesized light which is synthesized from the primary lights emitted from said primary light sources, comprising the step of: controlling the amount of the primary lights in a manner that the maximum value among differences between each of CIE chromaticity coordinates of the primary lights is kept to be 0.05 or larger and the primary lights are kept to have the same illuminance distribution characteristics to the extent that the color of the synthesized light is homogenized at a desired irradiated surface (claim 16).

[Advantageous effect of the invention]

According to a light source of the present invention, a desired irradiated surface can be irradiated with a homogenized-colored light having high color rendering, with high luminous efficiency.

And according to a light-emitting solid device module, phosphor module and illuminance-distribution element module of the present invention, component-by-component replacement of the light source of the present invention can be realized.

Furthermore, according to another light source of the present invention and a method for controlling light of the present invention, the color temperature of the light emitted can be controlled.

Furthermore, according to a lighting system and display of the present invention, at least either irradiating a desired irradiated surface with a homogenized-colored light having high color rendering with high luminous efficiency or controlling the color temperature of the light emitted can be realized.

Brief Description of the Drawings

[Fig. 1] Fig. 1 is a schematic drawing of "θ" and "Φ", illustrating an embodiment of the present invention.

[Fig. 2] Fig. 2 is a schematic exploded perspective view of the structure of the primary light source composed of the light-emitting solid device and illuminance-distribution controlling element according to an embodiment of the present invention.

[Fig. 3] Fig. 3 is a schematic exploded perspective view of the structure of the primary light source composed of the light-emitting solid device, phosphor section and illuminance-distribution controlling element according to an embodiment of the present invention.

[Fig. 4] Fig. 4 is a schematic exploded perspective view illustrating the light source composed of the light-emitting solid device module and illuminance-distribution element module according to an embodiment of the present invention.

[Fig. 5] Fig. 5 is a schematic exploded perspective view illustrating the light source composed of the light-emitting solid device module, phosphor module and illuminance-distribution element module according to an embodiment of the present invention.

[Fig. 6] Fig. 6 is a schematic exploded perspective view illustrating an example of the light source where light is controlled by the replacement, according to an embodiment of the present invention.

[Fig. 7] Fig. 7 is a schematic exploded perspective view illustrating an example of the light source where light is controlled by the primary-light controller, according to an embodiment of the present invention.

[Fig. 8] Fig. 8 is a schematic drawing of an arrangement of the primary light sources used in Examples 1 to 3 and Comparative Example 1 of the present invention.

[Fig. 9] Fig. 9 is a drawing of the relation between the irradiated surface and primary light sources in Examples 1 to 3 and Comparative Example 1 of the present invention.

[Fig. 10] Fig. 10 shows respective spectrums of red multipoint light source, green multipoint light source and blue multipoint light source, used in Examples 1 to 3 and Comparative Example 1 of the present invention.

[Fig. 11] Fig. 11 is a drawing illustrating irradiated surface of $Z = 10$ cm, obtained from the result of Example 1 of the present invention.

[Fig. 12] Fig. 12 is a drawing of the CIE chromaticity coordinates obtained from the result of Example 1 of the present invention and calculated at irradiated surface of $Z = 10$ cm, plotted on the CIE chromaticity diagram.

[Fig. 13] Fig. 13 is a drawing illustrating the irradiated surface of $Z = 250$ cm, obtained from the result of Example 1 of the present invention.

[Fig. 14] Fig. 14 is a drawing of the CIE chromaticity coordinates obtained from the result of Example 1 of the present invention and calculated at irradiated surface of $Z = 250$ cm, plotted on the CIE chromaticity diagram.

[Fig. 15] Fig. 15 is a drawing illustrating the irradiated surface at $Z = 10$ cm, obtained from the result of Example 2 of the present invention.

[Fig. 16] Fig. 16 is a drawing of the CIE chromaticity coordinates obtained from the result of Example 2 of the present invention and calculated at irradiated surface of Z = 10 cm, plotted on the CIE chromaticity diagram.

[Fig. 17] Fig. 17 is a drawing illustrating the irradiated surface at Z = 250 cm, obtained from the result of Example 2 of the present invention.

[Fig. 18] Fig. 18 is a drawing of the CIE chromaticity coordinates obtained from the result of Example 2 of the present invention and calculated at irradiated surface of Z = 250 cm, plotted on the CIE chromaticity diagram.

[Fig. 19] Fig. 19 is a drawing illustrating the irradiated surface at Z = 10 cm, obtained from the result of Example 3 of the present invention.

[Fig. 20] Fig. 20 is a drawing of the CIE chromaticity coordinates obtained from the result of Example 3 of the present invention and calculated at irradiated surface of Z = 10 cm, plotted on the CIE chromaticity diagram.

[Fig. 21] Fig. 21 is a drawing illustrating the irradiated surface at Z = 250 cm, obtained from the result of Example 3 of the present invention.

[Fig. 22] Fig. 22 is a drawing of the CIE chromaticity coordinates obtained from the result of Example 3 of the present invention and calculated at irradiated surface of Z = 250 cm, plotted on the CIE chromaticity diagram.

[Fig. 23] Fig. 23 is a drawing illustrating the irradiated surface at Z = 10 cm, obtained from the result of Comparative Example 1.

[Fig. 24] Fig. 24 is a drawing of the CIE chromaticity coordinates obtained from the result of Comparative Example 1 and calculated at irradiated surface of Z = 10 cm, plotted on the CIE chromaticity diagram.

[Fig. 25] Fig. 25 is a drawing illustrating the irradiated surface at Z = 250 cm, obtained from the result of Comparative Example 1.

[Fig. 26] Fig. 26 is a drawing of the CIE chromaticity coordinates obtained from the result of Comparative Example 1 and calculated at irradiated surface of Z = 250 cm, plotted on the CIE chromaticity diagram.

[Fig. 27] Fig. 27 is a drawing of the CIE chromaticity coordinates measured in Example 4 of the present invention, plotted on the CIE chromaticity diagram.

[Fig. 28] Fig. 28 is an enlarged drawing in the vicinity of the plots of Fig. 27.

[Fig. 29] Fig. 29 is a drawing of the CIE chromaticity coordinates measured in Comparative Example 2, plotted on the CIE chromaticity diagram.

[Explanation of Letters or Numerals]

| | |
|---|---|
| 1 | primary light source |
| 2 | light-emitting solid device |
| 3,3' | phosphor section |
| 4 | illuminance-distribution controlling element |
| 5 | light-emitting solid device module |
| 6,6' | phosphor module |
| 7 | illuminance-distribution element module |
| 8 | turntable |
| 9 | primary-light controller |
| 21 | LED body |
| 22,51,61,61',71 | base |
| 52 | wiring |
| 91 | supplied power controller |
| 92 | electric energy memory unit |

Best Modes for Carrying Out the Invention

The present invention will be explained below by referring to one embodiment. It is to be understood that the embodiments or the like shown below are by no means restrictive and any modifications can be added thereto insofar as they do not depart from the scope of the present invention.

[I. Light source]

The light source of the present invention comprises two or more primary light sources, each of which emits primary light having different wavelength, and emits synthesized light which is synthesized from the primary lights emitted from the primary light sources.

[1. Synthesized light]

The synthesized light of the present embodiment is light emitted from the light source of the present embodiment and is usually used to illuminate the desired irradiated surface. The irradiated surface here indicates a surface which the light source of the present embodiment intends to illuminate. The synthesized light of the present embodiment will be explained in detail below.

(i) Wavelength of the Synthesized light

The wavelength of the synthesized light of the present embodiment can be decided arbitrarily depending on the use or the like of the synthesized light. It is usually 400 nm or higher, preferably 420 nm or higher, more preferably 440 nm or higher, and usually 750 nm or lower, preferably 700 nm or lower, more preferably 650 nm or lower. When the wavelength is outside the above range, brightness may be too low as a light source. The wavelength of the synthesized light can be measured by, for example, photometric brightness meter or fluorescence spectrophotometer.

(ii) Intensity of the synthesized light

The luminance of the light source of the present embodiment can also be decided arbitrarily depending on the use or the like of the synthesized light. It is usually 1000 candela/m$^2$ or higher, preferably 5000 candela/m$^2$ or higher, more preferably 10000 candela/m$^2$ or higher, and usually 1000000 candela/m$^2$ or lower, preferably 500000 candela/m$^2$ or lower, more preferably 100000 candela/m$^2$ or lower. When the luminance is below the above lower range, the synthesized light may be too weak and the irradiated surface may be too dark, leading to impracticability of an lighting system (hereinafter referred to as "lighting" as appropriate) based on the light source of the present embodiment. When the above upper limit is exceeded, the synthesized light may be too dazzling and the light source of the present embodiment may not be used for lighting. The luminance of the synthesized light can be measured by luminance colorimeter.
In the light source of the present embodiment, the luminous efficiency of the synthesized light is usually 30 lm/W or higher, preferably 60 lm/W or higher, more preferably 100 lm/W or higher. When the luminous efficiency is below the above range, energy cost required at the time of use may be too large and the light source will not fulfill the demand characteristics as high energy-efficiency lighting system. Furthermore, when the luminous efficiency is below the above range, element destruction can occur because of heat generation, when the light sources are assembled as a display. Luminous efficiency of the light source can be measured by, for example, dividing the luminous flux of the synthesized light obtained by use of integrating sphere by the electric power supplied.

(iii) Color of the synthesized light

The color of the synthesized light of the present embodiment can also be decided arbitrarily depending on the use or the like of the synthesized light. Usually, it is preferable to make it such colors as white or color of a light bulb. Particularly preferable is white. By making the color of the synthesized light white, things look quite natural. In other words, things look closer to how they look in sunlight advantageously. In this context, white color indicates the white color defined in the color segmentation in JIS Z8110.
In relation to CIE chromaticity diagram, it is preferable to make the color of the synthesized light a color as close as possible to the blackbody radiation locus in the CIE chromaticity diagram.
The color of the synthesized light can be confirmed by the color of the irradiated surface, measured by luminance colorimeter or photometric brightness meter. The irradiated surface here means a surface which is intended to be illuminated by using the light source of the present embodiment. For example, when the light source of the present embodiment is used for indoor lighting system, a surface which is located 2.5 m or more away from the light source of the present embodiment can be used as irradiated surface to confirm the color of the synthesized light.

(iv) Color temperature of the synthesized light

The color temperature of the synthesized light of the present embodiment can also be decided arbitrarily depending on the use of the synthesized light. It is usually 2000 K or higher, preferably 2500 K or higher, more preferably 4000 K or higher, and usually 12000 K or lower, preferably 10000 K or lower, more preferably 7000 K or lower. Light in this range is used widely as it can make cold color and warm color look natural. When the color temperature is outside the above range, it is difficult to use the light source of the present embodiment for lighting fixtures of ordinary use. The color temperature of the synthesized light can be measured by, for example, luminance colorimeter or photometric brightness meter.

(v) Characteristics of the spectrum of the synthesized light

The spectrum of the synthesized light of the present embodiment is usually a combination of the spectra of the primary lights. It is preferable that the spectrum of the synthesized light is a continuous visible light, in order to obtain a lighting system with good color rendering, and furthermore, it is preferable that it is as close as possible to Planck's radiation.

The spectrum of the synthesized light can be measured by a spectrophotometer.

(vi) Extent of homogenization of color and distance enabling homogenization of color

Although the synthesized light according to the present embodiment is synthesized of the primary lights emitted from respective primary light sources, it is homogenized at an irradiated surface which is located a desired distance away from the light source of the present embodiment. In other words, primary lights having different wavelengths and colors from each other are emitted and form a homogenized-colored light at an irradiated surface which is located farther than a desired distance away. This phenomenon is not dependent on the location, intensity or kind of the primary light sources but can be realized by controlling the illuminance distribution characteristics. This amazing phenomenon was not known conventionally. The mechanism of this phenomenon will be explained later, together with the explanation of the primary light.

Homogenization of the color of the synthesized light indicates specifically that the differences between each of CIE chromaticity coordinates x and between each of CIE chromaticity coordinates y of the synthesized-light colors, measured at even any arbitral two points on the irradiated surface, falls within usually 0.05 or smaller, preferably 0.03 or smaller, and more preferably 0.02 or smaller.

In order to estimate the extent of homogenization of the color of the synthesized light, the surface of a perfectly diffuse reflector, located 144 times distance of the maximum distance value among ones between each different-colored primary light source, can be used as the irradiated surface for measurement on the above-mentioned CIE chromaticity coordinates. The distance between the light source and the irradiated surface indicates the smallest distance among ones between arbitral points on the light source and arbitral points on the irradiated surface. When the light source is used for an ordinal lighting system, the above estimation can be done by making the surface of a perfectly diffuse reflector, located 2.5 m away from the light source of the present embodiment, used as the irradiated surface for measurement on the above-mentioned CIE chromaticity coordinates. Specifically, the values of CIE chromaticity coordinates can be obtained by measuring the color of the above-mentioned standard-white reflector, having perfect diffusion characteristics, irradiated with the synthesized light.

Incidentally, the distance that can homogenize the color of the synthesized light, namely the distance from the light source of the present embodiment to the irradiated surface, can be arbitrary decided depending on its use or the like. Specifically, the distance can be set by adjusting the locations of the primary light sources of the present embodiment corresponding to the distance from the light source to the irradiated surface. Usually, when the light source of the present embodiment is used for an indoor lighting system at the ceiling, the distance from the light source to the irradiated surface is set to be about 2.5 m.

In addition, when the color of the synthesized light of the present embodiment is homogenized at the irradiated surface, the general color rendering index Ra of the synthesized light at the irradiated surface is usually 60 or larger, preferably 70 or larger, and more preferably 80 or larger. When the synthesized light is intended to show the color closer to the one in the sunlight, the general color rendering index Ra is further preferably 90 or larger, and particularly preferably 95 or larger.

The light source of the present embodiment, when seen directly itself, makes each of the primary lights visible, but when the irradiated surface irradiated with the synthesized light is seen, it appears that the irradiated surface is irradiated by a light of a simple color in which respective primary lights are homogeneously mixed. Therefore, the light source of the present embodiment can be treated as a light source which emits a synthesized light having different color from that of the primary lights.

[2. Primary light source]

[2-1. Primary light]

Primary light is light emitted from a primary light source. In the construction of a light source of the present embodiment, the primary light from each primary light source is combined to synthesize the intended synthesized light. The number of the kind of primary light (which is usually equal to the number of the kind of the primary light source) may be any number of two or more. From the standpoint of ease of construction of the device, it is usually 3 or 4.

The primary light will be explained in detail below.

(i) Wavelength of the primary light

The wavelength of the primary light of the present embodiment can be decided arbitrarily depending on its use or the like. The range and method of measurement of the wavelength of the primary light are usually the same as those described above for the synthesized light.

(ii) Luminance of the primary light

The luminance of the primary light of the present embodiment can also be decided arbitrarily depending on its use or the like. The luminance and method of its measurement of the primary light usually used are the same as those described above for the synthesized light.

(iii) Color of the primary light

The color of the primary light of the present embodiment can also be decided arbitrarily depending on its use or the like. For example, when the color of the synthesized light is white, the color of orange, yellow, green and blue can be combined. For the same purpose, namely when the color of the synthesized light is white, the color of red, green and blue can be combined. Of these examples, a combination of red, green and blue is usually employed as primary light. In this context, the definition of each color is as defined in the color segmentation in JIS Z8110.

When the light source of the present embodiment is used for a display or a specialized lighting system requiring considerable adjustment /modification of color tone, and if the color of the primary light is blue (with its central wavelength in the range of 440 nm to 460 nm), in relation to the CIE chromaticity diagram, it is desirable that the chromaticity coordinates x and y of the corresponding primary light in the CIE chromaticity diagram are as small as possible.

Further, if the color of the primary light is green (with its central wavelength in the range of 515 nm to 535 nm), it is desirable that the chromaticity coordinate y of the corresponding primary light in the CIE chromaticity diagram is as large as possible.

Further, if the color of the primary light is red (with its central wavelength in the range of 640 nm to 660 nm), it is desirable that the chromaticity coordinate x of the corresponding primary light in the CIE chromaticity diagram is as large as possible.

The above consideration is intended to make possible the synthesis of synthesized lights of versatile colors.

The color of the primary light can be measured in the same manner as that described for synthesized light.

(iv) Characteristics of the spectrum of the primary light

The spectrum of the synthesized light of the present embodiment is usually a combination of the spectra of the primary lights. When the light source of the present embodiment is used for a lighting system, it is usually preferable that the spectrum of the primary light is broad. It is further preferable that the spectrum of the synthesized light is a continuous spectrum. On the other hand, when the light source of the present embodiment is used for a display or a specialized lighting system requiring considerable adjustment / modification of color tone, it is usually preferable that the spectrum of the primary light is sharp. It is further preferable that the spectrum of the synthesized light is a spectrum having many independent peaks.

(v) Maximum value among differences between each of CIE chromaticity coordinates of the primary lights

In the light source of the present embodiment, the maximum value among differences between each of CIE chromaticity coordinates of the primary lights is usually 0.05 or more, preferably 0.1 or more, more preferably 0.2 or more, still more preferably 0.4 or more. This is because the color tone of the synthesized light of the present embodiment can then be adjustable in a wide range and the range of color reproduction can be made wider.

When there are two or more differences of CIE chromaticity coordinates of the primary lights, the maximum value among differences between each of CIE chromaticity coordinates means the greatest value of these differences. That this maximum value among differences between each of CIE chromaticity coordinates is in the above range means that the colors of the primary lights are different from each other. The difference between CIE chromaticity coordinates represents the larger difference of x chromaticity coordinate and y chromaticity coordinate between two or more kinds of light sources.

(vi) Illuminance distribution characteristics of primary light

In the light source of the present embodiment, the primary lights have the same illuminance distribution characteristics to the extent that the color of the synthesized light is homogenized at a desired irradiated surface. Because the primary light sources have the same illuminance distribution characteristics within a predetermined range as described above, with respect to a certain direction, the intensity ratios of the lights are constant, whether the distances from the primary light sources are the same or different. This is why the color of the synthesized light can be homogenized at the irradiated surface by making the illuminance distribution characteristics of the primary lights equalized within a predetermined range as described above.

The specific extent to which the illuminance distribution characteristics of the primary lights are homogenized can be decided arbitrary insofar as the advantageous effect of the present embodiment is not significantly impaired. For example, it is sufficient that all of the primary lights emitted from the primary light sources according to the present embodiment meet the following condition (A). "Condition (A): The value of

$$[|\Delta \mathrm{Iabs}(\theta,\phi)|]_{\max}$$

is usually 0.1 or smaller, preferably 0.08 or smaller, more preferably 0.05 or smaller, and further more preferably 0.01 or smaller."

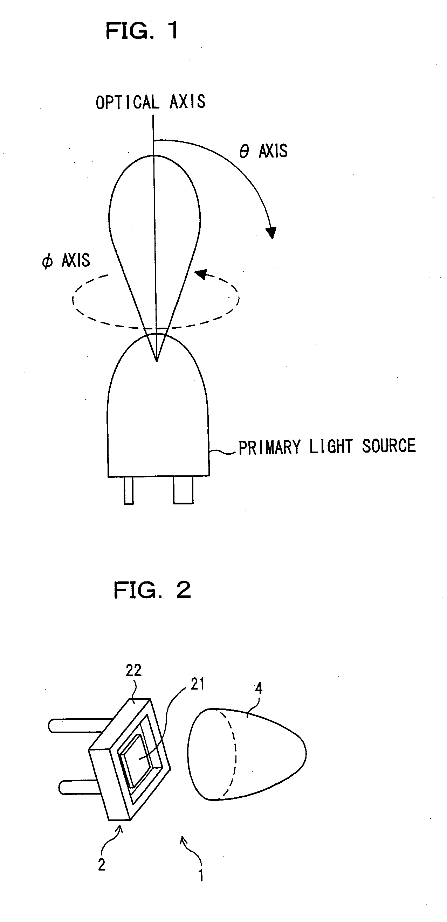

In condition (A), "θ" means the angle of inclination from the optical axis (the perpendicular line from the corresponding primary light source to the irradiated surface in this context), and "Φ" means the angle to the circumferential direction of the optical axis (the perpendicular line from the corresponding primary light source to the irradiated surface in this context). Fig. 1 shows these angles "θ", "Φ" schematically.

"Δlabs(θ,Φ)" means the difference between the normalized illuminance distributions of respective primary light sources in (θ,Φ) directions. A normalized illuminance distribution means, specifically, for example, each value of the illuminance distribution (wherein that of the primary light in the optical axis direction is set to be 1) divided by the maximum value of (θ,Φ), after examining intensity distributions in all (θ,Φ) directions except the optical axis direction. In other words, it means recalculated illuminance distribution in such manner as to make the maximum value of the intensities of the illuminance distribution in all (θ,Φ) directions be 1. And, "[ ]$_{\max}$" means the maximum value of the function within the parentheses "[ ]".

Put another way, "Δlabs (θ,Φ)" is as follows. When the normalized illuminance distribution emitted from a primary light source in the (θ,Φ) direction is indicated by "$I_1(\theta,\Phi)$", and the normalized illuminance distribution emitted from its comparative primary light source in the (θ,Φ) direction is indicated by "$I_2(\theta,\Phi)$", "|Δlabs(θ,Φ)|" is then shown by "$|I_1(\theta,\Phi)-I_2(\theta,\Phi)|$".

Accordingly, the above-mentioned condition (A) means that the above absolute value falls within the above range with respect to the light intensities in all directions, when calculating the absolute value of the difference of the normalized illuminance distributions of primary lights emitted from any selected two primary light sources comprised in the light source of the present embodiment. This also means the intensities of primary lights emitted from respective primary light sources are equalized in every direction.

By satisfying this condition (A), the illuminance distribution characteristics of the primary lights according to the present embodiment will be equalized to the extent that the color of the synthesized light is homogenized sufficiently at the irradiated surface. The color of the synthesized light according to the present embodiment can thereby be homogenized at the desired irradiated surface.

It also makes possible homogenization of the illuminance distribution characteristics of the primary lights according to the present embodiment to the extent as described above that all of the primary lights emitted from the primary light sources according to the present embodiment meet the following condition (B), for example. "Condition (B): The value of

$$\left[\int_0^{360}\phi\int_0^{90}\theta\ \Delta \mathrm{Iabs}(\theta,\phi)\mathrm{d}\,\theta\,\mathrm{d}\,\phi\right]_{\mathrm{average}}$$

is usually 10 or smaller, preferably 5 or smaller, more preferably 2 or smaller, and further more preferably 1 or smaller."

In condition (B), "θ", "Φ" and "Δlabs(θ,Φ)" mean the same as those defined in the explanation about condition (A). And, "[ ] average" means the average of the function within the parentheses "[ ]".

Accordingly, the above-mentioned condition (B) means that the average of integration value with respect to all the primary light sources falls within the above range, when integrating the difference of the normalized illuminance distributions of primary lights emitted from any selected two primary light sources comprised in the light source of the present embodiment in all directions. This also means the intensities of primary lights emitted from respective primary light sources according to the present embodiment are averagely equalized as a whole over every direction of the light emission.

By satisfying this condition (B), the illuminance distribution characteristics of the primary lights according to the present embodiment will be also equalized to the extent that the color of the synthesized light is homogenized sufficiently at the irradiated surface. The color of the synthesized light according to the present embodiment can thereby be homogenized at the desired irradiated surface.

Furthermore, it also makes possible homogenization of the illuminance distribution characteristics of the primary lights according to the present embodiment to the extent as described above that all of the primary lights emitted from the primary light sources according to the present embodiment meet the following condition (C), for example.

"Condition (C): The value of

$$\left[ \int_0^{360} \phi \int_0^{90} \theta \ \Delta \mathrm{Iabs}(\theta,\phi) \mathrm{d}\,\theta\,\mathrm{d}\,\phi \right]_{\max}$$

is usually 20 or smaller, preferably 10 or smaller, more preferably 4 or smaller, and further more preferably 2 or smaller."

In condition (C), "$\theta$", "$\Phi$", "$\Delta \mathrm{Iabs}(\theta,\Phi)$", and "$[\ ]_{\max}$" mean the same as those defined in the explanation about condition (A).

Accordingly, the above-mentioned condition (C) means that the maximum value of integration value with respect to all the primary light sources falls within the above range, when integrating the difference of the normalized illuminance distributions of primary lights emitted from any selected two primary light sources comprised in the light source of the present embodiment in all directions. This also means even a primary light source having most different illuminance distribution characteristics emits a primary light, the intensity of which is close to that of primary lights emitted from other primary light sources, as a whole in every direction of the light emission.

By satisfying this condition (C), the illuminance distribution characteristics of the primary lights according to the present embodiment will be also equalized to the extent that the color of the synthesized light is homogenized sufficiently at the irradiated surface. The color of the synthesized light according to the present embodiment can thereby be homogenized at the desired irradiated surface.

Whether the above-mentioned conditions (A) to (C) are met can be checked with, for example, an illuminance distribution characteristics evaluation equipment.

(vii) Spread angle of primary light

The spread angles, which show the ways lights spread with the illuminance distribution of the primary lights according to the present embodiment, can be decided arbitrary insofar as the advantage of the present embodiment is not significantly impaired. However, it is preferable that a part of, or preferably all of the spread angles are usually 5 degree or larger and usually 180 degree or smaller. The spread angle defines how wide and how intensive light can illuminate. In addition to the above-mentioned preferable range of spread-angle degree, it is further preferable that the spread angle is set to be large when the light source of the present embodiment is used as indoor lighting system or the like, and that it is set to be small when used as spotlight or the like.

The spread angle of the primary light can be measured by finding the angle, along $\theta$ direction, at which the intensity of the primary light shows 50 % value of the maximum.

[2-2. Structure of primary light source]

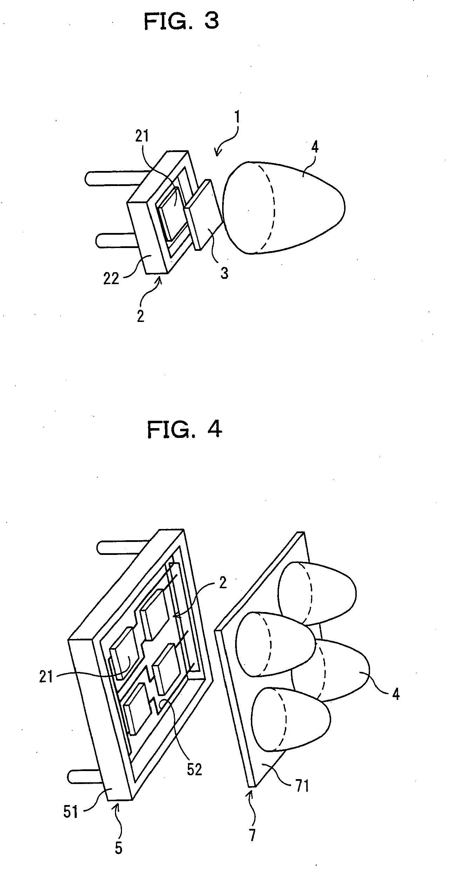

There is no limitation on the kind of the primary light source of the present embodiment insofar as it can emit the above-described primary light by which the light source of the present embodiment can emit the synthesized light according to the present embodiment. Any light sources such as field emission light source and cold cathode fluorescent lamp can be used. Also applicable are various light emitting devices including gas light emitting device or liquid light emitting device. Of these, it is preferable to use light-emitting solid device, for example. Particularly preferable examples are: primary light source 1 composed of light-emitting solid device 2 itself, as shown in Fig.2; and primary light source 1 composed of light-emitting solid device 2 and phosphor section 3 having a phosphor absorbing light from light-emitting solid device 2 and emitting light, as shown in Fig. 3. In addition, it is preferable that primary light source 1 comprises illuminance distribution controlling element 4 as appropriate. Fig. 2 is a schematic exploded perspective view of the structure of the primary light source composed of the light-emitting solid device and illuminance distribution controlling element. Fig. 3 is a schematic exploded perspective view of the structure of the primary light source composed of the light-emitting solid device, phosphor section and illuminance distribution controlling element. In Figs. 2 and 3, components designated by the same reference numerals are the same.

Respective examples are explained in the following.

[2-2-1. Primary light source composed of light-emitting solid device]

A light source 1 composed of light-emitting solid device 2, as shown in Fig. 2, will be described first.

(i) Light-emitting solid device

Light-emitting solid device 2 is a device emitting light by being supplied with energy from outside. Usually, a device emitting light by being supplied with electric power can be used.

There is no limitation on the material, shape, dimension or the like of light-emitting solid device 2, and any type of device can be used so long as the advantage of the present embodiment is not significantly impaired.

Though there is no limitation on the number of light-emitting solid device 2 included in one primary light source 1 either, usually one light-emitting solid device 2 is used in one primary light source 1.

When primary light source 1 is composed of light-emitting solid device 2, the light itself emitted from light-emitting solid device 2 comes to be a primary light of primary light source 1. Therefore, in this case, primary light sources emitting the primary light as explained in detail for the above "primary light" section can be used, as light-emitting solid device 2. Also in this case, light-emitting solid devices 2 each of which emits light with different wavelength are used as the light source of the present embodiment.

As examples of light-emitting solid device 2 can be cited: LED, surface emitting laser, near ultraviolet and blue emitting inorganic EL, and near ultraviolet and blue emitting organic EL. These devices can be used either singly or as a mixture of more than one kind in any combination and in any ratio. In a structure shown in Fig. 2, LED is used as light-emitting solid device 2.

There is no limitation on the luminous efficiency of light-emitting solid device 2, but usually one having high luminous efficiency is preferably used. Specifically, it is preferable that the luminous efficiency is usually 20 % or more, preferably 30 % or more, and more preferably 40 % or more.

Incidentally, in primary light source 1 shown in Fig. 2, LED body 21 of light-emitting solid device 2 is intended to be fixed on base 22, shaped planar in its primary-light emitting side, and constructed to be supplied with electric power through a wiring (not shown in Figs.) formed on base 21.

Constructing primary light source 1 using light-emitting solid device 2 as described above can achieve an advantageous effect which is increasing the luminous efficiency.

[2-2-2. Primary light source composed of light-emitting solid device and phosphor section]

A light source 1 composed of light-emitting solid device 2 and phosphor section 3, as shown in Fig. 3, will be described next.

(i) Light-emitting solid device

When primary light source 1 is composed of light-emitting solid device 2 and phosphor section 3, the same kind of light-emitting solid device 2 as described above for the case where the primary light source is composed of light-emitting solid device 2 can be used.

But in the case that primary light source 1 is composed of light-emitting solid device 2 and phosphor section 3, the light emitted by light-emitting solid device 2 is not necessary the same as the primary light described above, therefore, it is not necessary to be visible light. In other words, in the case that primary light source 1 is composed of light-emitting solid device 2 and phosphor section 3, in addition to the light emitted from light-emitting solid device 2 itself, the light emitted from the phosphor within phosphor section 3, which absorbs the light emitted from light-emitting solid device 2 can be used as the primary light. Therefore, light-emitting solid device 2 emitting light other than visible light (for example, ultraviolet), capable of exciting the phosphor within phosphor section 3, can be used. Specific characteristics such as wavelength and intensity of the light emitted by light-emitting solid device 2 can be set as appropriate corresponding to the relationship to the phosphor to be used.

In addition, in the case that primary light source 1 is composed of light-emitting solid device 2 and phosphor section 3, even light-emitting solid device 2 emitting light of the same wavelength as that from light-emitting solid device 2 used in the same light source can be used. This is because, the fluorescence emitted by phosphor section 3 can be used as the primary light, unlike when the primary light source is composed of light-emitting solid device 2, and therefore, light-emitting solid devices 2, the light of which is used as the excitation light for phosphor section 3, can emit the same light as each other.

(ii) Phosphor section

Phosphor section 3 is a member including a phosphor absorbing light from the light-emitting solid device 2 and emitting light.

There is no special limitation on the number, shape and dimension of the phosphor section 3, insofar as the advantage of the present embodiment is not significantly impaired. But usually, one phosphor section 3 is disposed for one primary light source 1.

There is no limitation on the construction of the phosphor section 3 so long as it can emit fluorescence. Any construction of a light emitting device using a phosphor can be used. Examples are: calcined phosphor, glass made of phosphor or manipulated single-crystalline phosphor. Usually, a powder of phosphor is mixed with a binder to make it.

There is no special limitation on the phosphor, insofar as it can absorb light from the light-emitting solid device 2 and emit light. Preferable is a phosphor which can be excited by near ultraviolet light whose wavelength is close to 400 nm. This is because high luminous efficiency can be realized by combining it with a near-UV LED having high luminous efficiency and used as light-emitting solid device so as to construct the primary light source.

No particular limitation is imposed on the mechanism of light emitting of the phosphor. Therefore, a light-storing phosphor can also be used as the phosphor. Use of light-storing phosphor makes possible the use of the light source of the present embodiment in a dark place preferably.

In the phosphor section 3, the phosphor can be used either singly or as a combination of two or more kinds in any combination and in any ratio.

There is no special limitation on the composition of the phosphor. Preferable examples are: metal oxides represented by $Y_2O_3$ and $Zn_2SiO_4$ (which are host crystals); phosphates represented by $Ca_5(PO_4)_3Cl$; and sulfides represented by $ZnS$, $SrS$ and $CaS$, to which are added rare earth metal ions of Ce, Pr, Nd, Pm, Sm, Eu, Tb, Dy, Ho, Er, Tm or Yb, or metal ions of Ag, Cu, Au, Al, Mn or Sb, as activator or coactivator.

As preferable examples of host crystal of the phosphor can be cited: sulfides such as $(Zn,Cd)S$, $SrGa_2S_4$, $SrS$ and $ZnS$; oxysulfides such as $Y_2O_2S$; aluminate compounds such as $(Y,Gd)_3Al_5O_{12}$, $YAlO_3$, $BaMgAl_{10}O_{17}$, $(Ba,Sr)(Mg,Mn)Al_{10}O_{17}$, $(Ba,Sr,Ca)$ $(Mg,Zn,Mn)Al_{10}O_{17}$, $BaAl_{12}O_{19}$, $CeMgAl_{11}O_{19}$, $(Ba,Sr,Mg)O·Al_2O_3$, $BaAl_2Si_2O_8$, $SrAl_2O_4$, $Sr_4Al_{14}O_{25}$ and $Y_3Al_5O_{12}$; silicate such as $Y_2SiO_5$ and $Zn_2SiO_4$; oxides such as $SnO_2$ and $Y_2O_3$; borates such as $GdMgB_5O_{10}$ and $(Y,Gd)BO_3$; halophosphates such as $Ca_{10}(PO_4)_6(F,Cl)_2$ and $(Sr,Ca,Ba,Mg)_{10}(PO_4)_6Cl_2$; phosphates such as $Sr_2P_2O_7$ and $(La,Ce)PO_4$.

No particular limitation is imposed on the element composition of the above host crystal and activator / coactivator. Partial substitution with the element of the same group is possible. Any phosphor obtained can be used so long as it absorbs light in the near ultraviolet to visible region and emits visible light.

More concretely, those listed below can be used as phosphor. The list shown below serves as an example and phosphors that can be used in the present invention are not limited to these examples. In the following examples, phosphors with different partial structure are shown abbreviated as a group for the sake of convenience. For example, 3 compounds of "$Y_2SiO_5:Ce^{3+}$", "$Y_2SiO_5:Tb^{3+}$" and "$Y_2SiO_5:Ce^{3+},Tb^{3+}$" are combined as "$Y_2SiO_5:Ce^{3+},Tb^{3+}$" and 3 compounds of "$La_2O_2S : Eu$", "$Y_2O_2S:Eu$" and "$(La,Y)_2O_2S:Eu$" are collectively shown as " $(La,Y)_2O_2S:Eu$". Abbreviated part is indicated by comma-separation.

Red phosphor:

An example of the wavelength range of fluorescence emitted by a phosphor which emits red fluorescence (referred to as "red phosphor" as appropriate) is as follows. Its peak wavelength is usually 570 nm or higher, preferably 580 nm or higher, and usually 700 nm or lower, preferably 680 nm or lower.

As examples of red phosphor can be cited europium-activated alkaline earth silicon nitride phosphors represented by $(Mg,Ca,Sr,Ba)_2Si_5N_8:Eu$, which is constituted by fractured particles having red fractured surface and emit light in the red region, and europium-activated rare earth oxychalcogenide phosphors represented by $(Y,La,Gd,Lu)_2O_2S:Eu$, which is constituted by growing particles having a nearly spherical shape typical of regular crystal growth and emit light in the red region.

Also applicable in the present embodiment is an phosphor containing oxynitride and/or oxysulfide which contains at least one element selected from the group consisting of Ti, Zr, Hf, Nb, Ta, W and Mo, as described in Japanese Patent Laid-Open Publication (Kokai) No. 2004-300247, and containing an oxynitride having an $\alpha$-sialon structure in which all or part of Al element is replaced by Ga element. These are phosphors which contain oxynitride and/or oxysulfide.

Other examples of red phosphors include: Eu-activated oxysulfide such as $(La,Y)_2O_2S:Eu$; Eu-activated oxide such as $Y(V,P)O_4:Eu$ and $Y_2O_3:Eu$; Eu,Mn-activated silicate such as $(Ba, Sr, Ca, Mg)_2SiO_4:Eu, Mn$ and $(Ba, Mg)_2SiO_4:Eu, Mn$; Eu-activated sulfide such as $(Ca,Sr)S:Eu$; Eu-activated aluminate such as $YAlO_3:Eu$; Eu-activated silicate such as $LiY_9(SiO_4)_6O_2:Eu$, $Ca_2Y_8(SiO_4)_6O_2:Eu$, $(Sr,Ba,Ca)_3SiO_5:Eu$ and $Sr_2BaSiO_5:Eu$; Ce-activated aluminate such as $(Y, Gd)_3Al_5O_{12}:Ce$ and $(Tb,Gd)_3Al_5O_{12}:Ce$; Eu-activated nitride such as $(Ca,Sr,Ba)_2Si_5N_8:Eu$, $(Mg,Ca,Sr,Ba)SiN_2:Eu$ and

(Mg,Ca,Sr,Ba)AlSiN$_3$:Eu; Ce-activated nitride such as (Mg,Ca,Sr,Ba)AlSiN$_3$:Ce; Eu,Mn-activated halophosphate such as (Sr,Ca,Ba,Mg)$_{10}$(PO4)$_6$Cl$_2$:Eu,Mn; Eu,Mn-activated silicate such as (Ba$_3$Mg)Si$_2$O$_8$:Eu,Mn and (Ba,Sr,Ca,Mg)$_3$(Zn,Mg)Si$_2$O$_8$:Eu,Mn; Mn-activated germanate such as 3.5MgO · 0.5MgF$_2$ · GeO$_2$:Mn; Eu-activated oxynitride such as Eu-activated α-sialon; Eu, Bi-activated oxide such as (Gd,Y,Lu,La)$_2$O$_3$:Eu,Bi; Eu,Bi-activated oxysulfide such as (Gd,Y,Lu,La)$_2$O$_2$S: Eu,Bi; Eu,Bi-activated vanadate such as (Gd,Y,Lu,La)VO$_4$:Eu;Bi;Eu,Ce-activated sulfide such as SrY$_2$S$_4$:Eu,Ce; Ce-activated sulfide such as CaLa$_2$S$_4$:Ce; Eu,Mn-activated phosphate such as (Ba,Sr,Ca)MgP$_2$O$_7$:Eu,Mn and (Sr,Ca,Ba,Mg,Zn)$_2$P$_2$O$_7$:Eu,Mn; Eu,Mo-activated tungstate such as (Y,Lu)$_2$WO$_6$:Eu,Mo; Eu,Ce-activated nitride such as (Ba,Sr,Ca)$_x$Si$_y$N$_z$:Eu,Ce (x,y,z being an integer of 1 or larger); Eu,Mn-activated halophosphate such as (Ca,Sr,Ba,Mg)$_{10}$(PO$_4$)$_6$(F,Cl,Br,OH):Eu,Mn;Ce-activated silicate such as ((Y,Lu,Gd,Tb)$_{1-x}$SC$_x$Ce$_y$)$_2$(Ca,Mg)$_{1-r}$(Mg,Zn)$_{2+r}$Si$_{z-q}$Ge$_q$O$_{12+\delta}$.

Also applicable as red phosphor are the following examples: red organic phosphor consisting of rare earth ion complex containing anions such as β-diketonate, β-diketone, aromatic carboxylic acid or Broensted acid as ligand, perylene pigment (for example, dibenzo {[f,f']-4,4',7,7'-tetraphenyl} diindeno [1,2,3-cd:1',2',3'-1m] perylene), anthraquinone pigment, lake pigment, azo pigment, quinacridone pigment, anthracene pigment, isoindoline pigment, isoindolinone pigment, phthalocyanine pigment, triphenylmethane series basic dye, indanthrone pigment, indophenol pigment, cyanine pigment and dioxazine pigment.

· Green phosphor

An example of the wavelength range of fluorescence emitted by a phosphor which emits green fluorescence (referred to as "green phosphor" as appropriate) is as follows. Its peak wavelength is usually 490 nm or higher, preferably 500 nm or higher, and usually 570 nm or lower, preferably 550 nm or lower.

As examples of green phosphor can be cited europium-activated alkaline earth silicon oxynitride phosphors represented by (Mg, Ca, Sr, Ba) Si$_2$O$_2$N$_2$: Eu, which is constituted by fractured particles having a fractured surface and emit light in the green region, and europium-activated alkaline earth silicate phosphors represented by (Ba, Ca, Sr, Mg)$_2$SiO$_4$:Eu, which is constituted by fractured particles having a fractured surface and emit light in the green region.

Other examples of green phosphors include: Eu-activated aluminate such as Sr$_4$Al$_{14}$O$_{25}$ : Eu and (Ba,Sr,Ca)Al$_2$O$_4$:Eu; Eu-activated silicate such as (Sr,Ba)Al$_2$Si$_2$O$_8$:Eu, (Ba,Mg)$_2$SiO$_4$:Eu, (Ba,Sr,Ca,Mg)$_2$SiO$_4$:Eu and (Ba,Sr,Ca)$_2$(Mg,Zn)Si$_2$O$_7$:Eu; Ce,Tb-activated silicate such as Y$_2$SiO$_5$:Ce,T$_b$;Eu-activated borophosphate such as Sr$_2$P$_2$O$_7$-Sr$_2$B$_2$O$_5$:Eu; Eu-activated halosilicate such as Sr$_2$Si$_3$O$_8$-2SrCl$_2$:Eu; Mn-activated silicate such as Zn$_2$SiO$_4$:Mn; Tb-activated aluminate such as CeMgAl$_{11}$O$_{19}$:Tb and Y$_3$Al$_5$O$_{12}$:Tb; Tb-activated silicate such as Ca$_2$Y$_8$(SiO$_4$)$_6$O$_2$:Tb and La$_3$Ga$_5$SiO$_{14}$:Tb; Eu,Tb,Sm-activated thiogalate such as (Sr,Ba,Ca)Ga$_2$S9:Eu,Tb,Sm; Ce-activated aluminate such as Y$_3$(Al,Ga)$_5$O$_{12}$:Ce and (Y,Ga,Tb,La,Sm,Pr,Lu)$_3$(Al,Ga)$_5$O$_{12}$:Ce; Ce-activated silicate such as Ca$_3$Sc$_2$Si$_3$O$_{12}$: Ce and Ca$_3$(Sc,Mg,Na,Li)$_2$Si$_3$O$_{12}$:Ce; Ce-activated oxide such as CaSc$_2$O$_4$:Ce; Eu-activated oxynitride such as SrSi$_2$O$_2$N$_2$: Eu, (Sr,Ba,Ca)Si$_2$O$_2$N$_2$:Eu, Eu-activated β-sialon and Eu-activated α-sialon; Eu,Mn-activated aluminate such as BaMgAl$_{10}$O$_{17}$:Eu; Eu-activated aluminate such as SrAl$_2$O$_4$:Eu; Tb-activated oxysulfide such as (La,Gd,Y)$_2$O$_2$S:Tb;Ce, Tb-activated phosphate such as LaPO$_4$:Ce,Tb; sulfide such as ZnS:Cu,Al,ZnS:Cu,Au,Al; Ce,Tb-activated borate such as (Y,Ga,Lu,Sc,La)BO$_3$:Ce,Tb, Na$_2$Gd$_2$B$_2$O$_7$:Ce,Tb and (Ba,Sr)$_2$(Ca,Mg,Zn)B$_2$O$_6$:K,Ce,Tb; Eu,Mn-activated halosilicate such as Ca$_8$Mg(SiO$_4$)$_4$Cl$_2$:Eu,Mn; Eu-activated thioaluminate or thiogallate such as (Sr,Ca,Ba) (Al,Ga,In)$_2$S$_4$:Eu ; Eu,Mn-activated halosilicate such as (Ca,Sr)$_8$(Mg,Zn) (SiO$_4$)$_4$Cl$_2$:Eu,Mn.

Also applicable as green phosphor are fluorescent pigment such as pyridine-phthalimide condensation product, benzoxadinone compound, quinazolinone compound, coumarine compound, quinophthalone compound and naphthalic imide compound, and organic phosphor such as terbium complex.

· Blue phosphor

An example of the wavelength range of fluorescence emitted by a phosphor which emits blue fluorescence (referred to as "blue phosphor" as appropriate) is as follows. Its peak wavelength is usually 420 nm or higher, preferably 440 nm or higher, and usually 480 nm or lower, preferably 470 nm or lower.

As examples of blue phosphor can be cited europium-activated barium magnesium aluminate phosphors represented by BaMgAl$_{10}$O$_{17}$:Eu, which is constituted by growing particles having a nearly hexagonal shape typical of regular crystal growth and emit light in the blue region, europium-activated calcium halphosphate phosphors represented by (Ca,Sr,Ba)$_5$(PO$_4$)$_3$Cl:Eu, which is constituted by growing particles having a nearly spherical shape typical of regular crystal growth and emit light in the blue region, europium-activated alkaline earth chloroborate phosphors represented by (Ca,Sr,Ba)$_2$B$_5$O$_9$Cl:Eu, which is constituted by growing particles having a nearly cubic shape typical of regular crystal growth and emit light in the blue region, and europium-activated alkaline earth aluminate phosphors represented by (Sr, Ca,Ba)Al$_2$O$_4$:Eu or (Sr,Ca,Ba)$_4$Al$_{14}$O$_{25}$:Eu, which is constituted by fractured particles having fractured surface and emit light in the blue region.

Other examples of blue phosphors include: Sn-activated phosphate such as Sr$_2$P$_2$O$_7$:Sn; Eu-activated alumi-

nate such as $Sr_4AL_{14}O_{25}$:Eu, $BaMgAl_{10}O_{17}$:Eu and $BaAl_8O_{13}$: Eu; Ce-actiated thiogallate such as $SrGa_2S_4$:Ce and $CaGa_2S_4$:Ce; Eu-activated aluminate such as $(Ba,Sr,Ca)MgAl_{10}O_{17}$:Eu and $BaMgAl_{10}O_{17}$:Eu,Tb,Sm; Eu,Mn-activated aluminate such as $(Ba,Sr,Ca)MgAl_{10}O_{17}$:Eu,Mn; Eu-activated halophosphate such as $(Sr,Ca,Ba,Mg)_{10}(PO_4)_6Cl_2$:Eu and $(Ba,Sr,Ca)_5(PO_4)_3(Cl,F,Br,OH)$:Eu,Mn,Sb;Eu-activated silicate such as $BaAl_2Si_2O_8$ :Eu, $(Sr,Ba)_3MgSi_2O_8$:Eu; Eu-activated phosphate such as $Sr_2P_2O_7$ : Eu ; sulfide such as ZnS:Ag,ZnS:Ag,Al; Ce-activated silicate such as $Y_2SiO_5$: Ce; tungstate such as $CaWO_4$; Eu,Mn-activated borophosphate such as $(Ba,Sr,Ca)BPO_5$:Eu,Mn, $(Sr,Ca)_{10}$ $(PO_4)_6 \cdot nB_2O_3$:Eu and $2SrO \cdot 0.84P_2O_5 \cdot 0.16B_2O_3$:Eu; Eu-activated halosilicate such as $Sr_2Si_3O_s \cdot 2SrCl_2$:Eu.

Also applicable as blue phosphor are fluorescent dyes such as naphthalic imide compound, benzoxazole compound,styryl compound, coumarine compound, pyralizone compound and triazole compound, and organic phosphor such as thulium complex.

On the other hand, no particular limitation is imposed on the binder, insofar as it can hold the phosphor in a desired position. Any binder can be used so long as the advantage of the present embodiment is not significantly impaired. Examples are organic materials such as thermoplastic resin, thermosetting resin and light curing resin, and inorganic materials such as glass.

As concrete examples of organic materials can be cited: methacrylate resin such as methyl polymethacrylate; styrene resin such as polystyrene and styrene-acrylonitrile copolymer; polycarbonate resin; polyester resin; phenoxy resin; butyral resin; polyvinylalcohol; cellulose resin such as ethyl cellulose, cellulose acetate and cellulose acetate butyrate; epoxy resin; phenol resin; and silicone resin. Examples of inorganic materials are glass, metal alkoxide, solution produced by hydrolysis /polymerization of a solution containing ceramic precursor polymer or metal alkoxide by the sol / gel method, inorganic material obtained by solidifying a combination of these, for example, inorganic material possessing siloxane bond.

Of these, use of inorganic material such as glass is preferable,as it is possible to prevent deterioration of the light source. However, when the primary light source is constructed as transmission type as shown in Fig. 3, it is preferable that the binder allows the transmission of light emitted by light-emitting solid device 2 and fluorescence emitted by the phosphor.

In each phosphor section 3, the binder can be used either singly or as a combination of two or more kinds in any combination and in any ratio.

Furthermore, when the phosphor section 3 is composed of a phosphor and a binder, the phosphor section 3 can contain other substances than the phosphor and binder, insofar as the advantage of the present embodiment is not significantly impaired. These substances include a pigment used for control of color tone, antioxidant, phosphorus compound stabilizer for processing, oxidation and heat, light-resistant stabilizer such as UV absorbing agent and silane coupling agent.

Each amount of phosphor and binder to be used for phosphor section 3 can be decided arbitrary, insofar as the advantage of the present embodiment is not significantly impaired. However, with respect to the ratio between the amounts of phosphor and binder, the weight ratio of the phosphor in the total weight of the phosphor and binder is usually 1 % or more, preferably 5 % or more, and usually 50 % or less, preferably 30 % or less, more preferably 15 % or less, due to high collection efficiency of fluorescence that can be obtained from the phosphor.

(iii) Specific constitution

When primary light source 1 is composed of light-emitting solid device 2 and phosphor section 3, there is no limitation on the positional relationship between light-emitting solid device 2 and phosphor section 3, insofar as primary light source 1 can emit the primary light. Therefore, primary light source 1 can be constructed to be transmissive type, which is composed in such a way that the light emitted from light-emitting solid device 2 is absorbed in the phosphor on the way it penetrates phosphor section 3 and makes the phosphor emit light. Or it also can be reflection type, which is composed in such a way that the light emitted from light-emitting solid device 2 is absorbed in the phosphor in phosphor section 3, when reflected at phosphor section 3, and makes the phosphor emit light.

In primary light source 1 shown in Fig. 3, light-emitting solid device 2 is, similarly to the one shown in Fig. 2, consisting of LED body 21 and base 22, and constructed to be supplied with electric power through a wiring which is not shown in Figs. And it is constructed in such a way that the light emitted from this light-emitting solid device 2 is used as an excitation light for phosphor section 3 and then the fluorescence generated within phosphor section 3 is emitted, as primary light, toward the irradiated surface out of the surface of phosphor section 3, which is opposite to light-emitting solid device 2.

By constructing primary light source 1 according to the present embodiment such as to consist of light-emitting solid device 2 and phosphor section 3, as described above, an advantageous effect of ease in aligning the illuminance distribution characteristics of the primary light. This is because axially-symmetric primary light can be easily realized by using phosphor section 3. Another advantageous effect of increasing above-mentioned color rendering of the synthesized light according to the present embodiment can be also realized. This is because, by using phosphor section 3, the primary light is diffused by the phosphor particles and therefore the spectrum of the primary light tend to be broad.

In order to make the primary light axially-symmetric by spreading the spread angle of the primary light uniformly, it is desirable that the size of particles of the phosphor be adjusted in a manner that a lot of primary light can be diffused by the phosphor particles. Specifically, particles with median particle size of 1 to. 50 $\mu$m are usually used as phosphor particles of the present embodiment. However, it is preferable that they contain at least 10 weight % of particles with particle diameter of 10 $\mu$m or smaller. More preferably, they contain at least 10 weight % of particles with particle diameter of 5 $\mu$m or smaller. Further more preferably, they contain at least 10 weight % of particles with particle diameter of 2 $\mu$m or smaller.

It is not preferable that the median particle size of the phosphor is below 1 $\mu$m, because the intensity of the fluorescence is so small that a light source with high efficiency may not be obtained. It is not either preferable that the median particle size of the phosphor is above 50 $\mu$m, because it may be difficult to obtain fluorescence which is homogenized in every direction with respect to the light source. As a result, it is preferable that the median particle size of the phosphor is usually 2 $\mu$m or larger, preferably 3 $\mu$m or larger, more preferably 5 $\mu$m or larger, and usually 40 $\mu$m or smaller, preferably 30 $\mu$m or smaller, more preferably 20 $\mu$m or smaller.

Furthermore, it is preferable that each of the phosphor particles having different fluorescent colors, used in phosphor sections 3 of different primary light sources 1, is nearly the same as each in median particle size and particle size distribution, on the ground that primary light sources having the same illuminance distribution characteristics can be obtained. This is because different median particle size and particle size distribution of the phosphor particles make illuminance distribution of the primary light, diffused by phosphor particles, different. Therefore, it is preferable that the median particle sizes of the different phosphor particles to be used, having different fluorescent colors, are adjusted among the plurality of phosphors used in a manner that the ratio between the maximum and minimum value of the median particle size is 3 or smaller. It is more preferable that the maximum and minimum value are nearly the same.

In addition, it is preferable that the content of phosphor particles having small particle size, which shows high light-scattering effect, in all different phosphor particles to be used, having different fluorescent colors, is adjusted among the different phosphors in a manner that the ratio between the maximum and minimum value is 3 or smaller. It is more preferable that the maximum and minimum value are nearly the same.

[2-2-3. Illuminance distribution controlling element]

It is preferable that primary light source 1 comprises illuminance-distribution controlling element 4 as appropriate, as shown in Fig. 2 or 3, for the purpose of equalization of the illuminance distribution characteristics of the primary lights as described above.

Any illuminance-distribution controlling element 4 can be used insofar as it can control the illuminance distribution characteristics of the primary lights emitted from primary light source 1.

Particularly, it is preferable that illuminance-distribution controlling element 4 has capability of collecting the primary light. By this capability, the illumination intensity, with which the irradiated surface is irradiated using the synthesized light of the present embodiment, can be heightened.

As examples of illuminance-distribution controlling element 4 can be cited: lens, waveguides (fiber optics, etc.) and photonic crystals. As another example, a phosphor can be incorporated within a lens. As still another example, phosphor section 3 and illuminance-distribution controlling element 4 may be formed as the same component, with phosphor section 3 formed to be lens-shaped.

By using illuminance-distribution controlling element 4, an advantageous effect of ease in aligning the illuminance distribution characteristics of the primary light can be achieved.

Incidentally, primary light source 1 may comprise any extra components other than above-mentioned light-emitting solid device 2, phosphor section 3 or illuminance-distribution controlling element 4, insofar as the advantage of the present embodiment is not significantly impaired.

[2-3. Relationship between constitution of primary light source and characteristics of primary light]

The primary lights according to the present embodiment have nearly the same illuminance distribution characteristics to the extent as mentioned above. In order to achieve this characteristics, it is preferable to constitute primary light source 1 according to the present embodiment paying attention to the following points. Namely, it is desirable to equalize the kinds of primary light sources 1 in a way that those light sources have the same type of illuminance distribution characteristics. In addition, it is desirable to equalize the illuminance distribution characteristics of each primary light source 1 along $\theta$ and $\Phi$ directions. These features can be accomplished by equalizing, for example, kind or shape of illuminance distribution controlling element 4 used in each primary light source 1.

Furthermore, it is desirable that the direction, in which the primary light is emitted from each primary light source 1, should be equalized. It is also desirable that the primary light sources with and without phosphor section 3 should not be used together.

In addition, it is desirable that the temperature characteristics of each primary light source 1 is equalized. Specifically, primary light sources used have temperature conditions, such as temperature during an emission, usable temperature or temperature which tends to induce deterioration, as close as possible to each other.

[2-4. Relation between primary light sources]

In the light source of the present embodiment, the distance between each primary light source 1 is arbitral, so long as the advantage of the present embodiment is not impaired. Usually, the distance between each primary light source 1 varies depending on the distance from the light source of the present embodiment to the irradiated surface. Specifically, the construction is set such that the maximum value of the distance between primary light sources 1 having different colors is one-144th of the distance from the light source of the present embodiment to the irradiated surface. In this context, the distance from the light source to the irradiated surface indicates the same as described above for the explanation on the homogenization of the synthesized light of the present embodiment.

In addition, the arrangement pattern of primary light sources 1 can be decided arbitrary, so long as the advantage of the present embodiment is not impaired. Usually, each primary light source 1 is disposed on the same plane to the extent that each of them can maintain its illuminance distribution characteristics. More specifically, it is usually desirable that they are disposed in matrix form, and it is also desirable that they are disposed regularly.

In this relation, it is desirable that primary light sources 1 are disposed as widely occupying the space as possible. This is why it is more desirable that the side of the primary light source, from which the primary light is emitted, is formed rectangular or the like, than formed circular.

[3. Constitution of light source by modules]

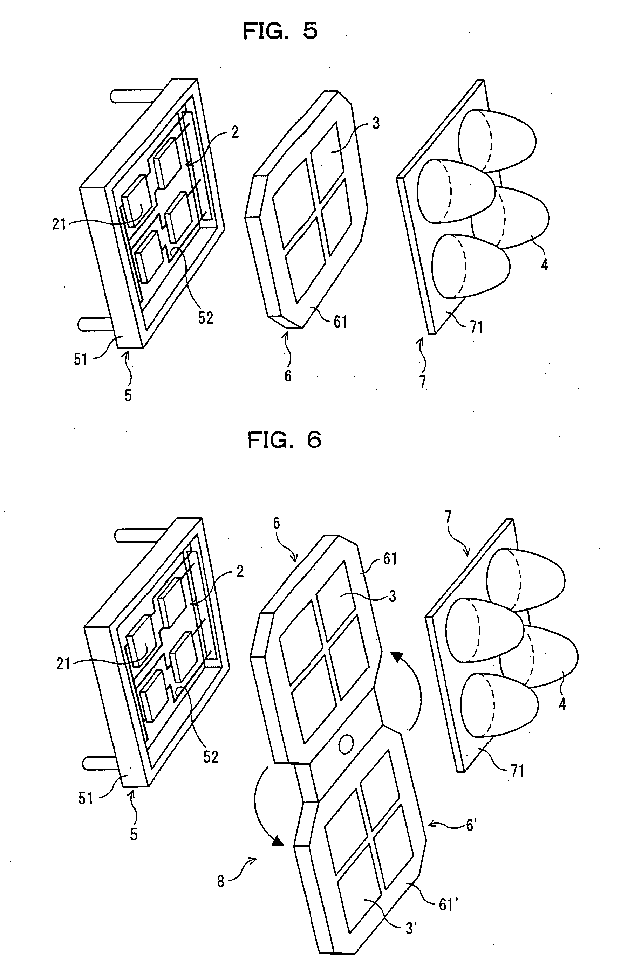

All or part of light-emitting solid device 2, phosphor section 3 and illuminance-distribution controlling element 4, which are components constituting the light source of the present embodiment, can be modularized, as shown in Fig. 4 or 5, for example. Hereinafter, modularized light-emitting solid device 2 is referred to as "light-emitting solid device module", modularized phosphor section 3 is referred to as "phosphor module", and modularized illuminance-distribution controlling element 4 is referred to as "illuminance-distribution element module", as appropriate. Fig. 4 is a schematic exploded perspective view illustrating the light source composed of the light-emitting solid device module and illuminance-distribution element module. Fig. 5 is a schematic exploded perspective view illustrating the light source composed of the light-emitting solid device module, phosphor module and illuminance-distribution element module. In Fig. 4, components designated by the same reference numerals as in Figs. 2 and 3 are the same as those of Figs. 2 and 3. In Fig. 5, components designated by the same reference numerals as in Figs. 2 to 4 are the same as those of Figs. 2 to 4.

Respective modules are explained in the following.

[3-1. Light-emitting solid device module]

As shown in Figs. 4 and 5, light-emitting solid device module 5 is a component constituting the light source of the present embodiment, together with phosphor section 3, illuminance-distribution controlling element 4 and other components, and it comprises the above-mentioned light-emitting solid device 2.

[3-1-1. Constitution of light-emitting solid device module]

Light-emitting solid device module 5 comprises base 51 and light emitting devices 2.

(i) Base

Base 51 of light-emitting solid device module 5 is a component to fix light-emitting solid devices 2 thereon.

There is no limitation on the kind of base 51 of light-emitting solid device module 5. It can be constituted with any material, shape or dimension, insofar as it withstands the conditions during use of the light source of the present embodiment, such as temperature condition, as well as insofar as the advantage of the present embodiment is not significantly impaired.

Base 51 can be provided with a mounting bracket which can mount phosphor section 3, illuminance-distribution controlling element 4, phosphor module 6, illuminance-distribution element module 7 or the like, as appropriate.

(ii) Light-emitting solid device

As light-emitting solid device 2, the one which is the same as mentioned above as a component constituting the primary light source can be used. Therefore, usually at least as many light-emitting solid devices 2 as the kinds of the primary lights should be provided on light-emitting solid device module 5, as shown in Fig. 4, when light-emitting solid device 2 itself constitutes the primary light source.

When the primary light source is composed of light-emitting solid device 2 and phosphor section 3, as shown in Fig. 5, at least one light-emitting solid device 2 should be provided on light-emitting solid device module 5. In this case, construction may be such that light-emitting solid device 2 can be shared by two or more phosphor sections 3.

In addition, light-emitting solid device 2 may be constructed to function not only as the primary light source but also as the excitation-light source for phosphor section 3. Also in this case, at least one light-emitting solid device may be provided on light-emitting solid device module 5.

(iii) Other component

Light-emitting solid device module 5 may contain any extra components other than base 51 or light-emitting solid device 2. For example, wiring 52 for supplying electric power to light-emitting solid device 2 may be provided. This wiring 52 is usually formed at base 51 of light-emitting solid device module 5.

In the example shown in Fig. 4 or 5, light-emitting solid device module 5 is intended to be constructed in such manner as to comprise four LEDs at base 51 and be able to supply electric power to these through wiring 52 formed on base 51.

[3-1-2. Use of light-emitting solid device module]

Although light-emitting solid device module 5 can constitute the light source of the present embodiment in itself, it is usually constitutes the light source of the present embodiment combined with illuminance-distribution controlling element 4 (including illuminance-distribution element module 7), as shown in Fig. 4. It can also constitute the light source of the present embodiment combined with illuminance-distribution controlling element 4 (including illuminance-distribution element module 7) and phosphor section 3 (including phosphor module 6), as shown in Fig. 5.

[3-2. Phosphor module]

As shown in Fig. 5, phosphor module 6 is a component constituting the light source of the present embodiment, together with light-emitting solid device 2, illuminance-distribution controlling element 4 and other components, and it comprises the above-mentioned phosphor section 3.

[3-2-1. Constitution of phosphor module]

Phosphor module 6 comprises base 61 and phosphor sections 3.

(i) Base

Base 61 of phosphor module 6 is a component to fix phosphor sections 3 thereon.

There is no limitation on the kind of base 61 of phosphor module 6. It can be constituted with any material, shape or dimension, insofar as it withstands the conditions during use of the light source of the present embodiment, such as temperature condition, as well as insofar as the advantage of the present embodiment is not significantly impaired.

Base 61 can be provided with a mounting bracket which can mount light-emitting solid device 2, ill-uminance-distribution controlling element 4, light emitting device module 5, illuminance-distribution element module 7 or the like, as appropriate.

(ii) Phosphor section

As phosphor section 3, the one which is the same as mentioned above can be used.

(iii) Other component

Phosphor module 6 may contain any extra components other than base 61 or phosphor section 3.

In the example shown in Fig. 5, phosphor module 6 is intended to be constructed in such manner as to comprise four phosphor sections 3, containing phosphors being excited by lights from light-emitting solid device 2 and emitting different-colored fluorescences, at base 61, and emit fluorescence (namely, the primary light) out of the front side (right side in the figure) after receiving the excitation light emitted from the corresponding light-emitting solid device 2 from back side (left side in the figure).

[3-2-2. Use of phosphor module]

Phosphor module 6 usually constitutes the light source of the present embodiment combined with light-emitting solid device 2 (including light-emitting solid device module 5), or combined with light-emitting solid device 2 (including light-emitting solid device module 5) and illuminance-distribution controlling element 7 (including illuminance-distribution element module 7).

[3-3. Illuminance-distribution element module]

As shown in Figs. 4 and 5, illuminance-distribution element module 7 is a component constituting the light source of the present embodiment, together with light-emitting solid device 2, phosphor section 3 and other components, and it usually comprises the above-mentioned illuminance-distribution controlling element 4. However, the use of illuminance-distribution element module 7 is arbitral and it is not essential to the light source of the present embodiment. But it is desirable to use it, from the standpoint of enhancing the illuminance distribution characteristics or the like.

[3-3-1. Constitution of illuminance-distribution element module]

Illuminance-distribution element module 7 comprises base 71 and illuminance-distribution controlling element 4.

(i) Base

Base 71 of illuminance-distribution element module 7 is a component to fix illuminance-distribution controlling element 4 thereon.
There is no limitation on the kind of base 71 of illuminance-distribution element module 7. It can be constituted with any material, shape or dimension, insofar as it withstands the conditions during use of the light source of the present embodiment, such as temperature condition, as well as insofar as the advantage of the present embodiment is not significantly impaired.
Base 71 can be provided with a mounting bracket which can mount light-emitting solid device 2, phosphor section 3, light emitting device module 5, phosphor module 6 or the like, as appropriate.

(ii) Illuminance-distribution controlling element

As illuminance-distribution controlling element 4, the one which is the same as mentioned above can be used.

(iii) Other component

Illuminance-distribution element module 7 may contain any extra components other than base 71 or illuminance-distribution controlling element 4.
In the example shown in Fig. 4 or 5, illuminance-distribution element module 7 is intended to be constructed in such manner as to comprise four illuminance-distribution controlling elements 4, for equalizing the illuminance distribution characteristics of the light from light-emitting solid device 2 or phosphor section 3, at base 71, receive light from back side (left side in the figure), equalize the light in its illuminance distribution characteristics, and emit the light out of the front side (right side in the figure).

[3-3-2. Use of illuminance-distribution element module]

Illuminance-distribution element module 7 usually constitutes the light source of the present embodiment combined with light-emitting solid device 2 (including light-emitting solid device module 5), or combined with light-emitting solid device 2 (including light-emitting solid device module 5) and phosphor section 3 (including phosphor module 6).

[3-4. Light source constituted from modules]

As shown in Fig. 4 or 5, combining light-emitting solid device module 5, phosphor module 6 and illuminance-distribution element module 7 appropriately makes possible constituting the above-mentioned light source of the present embodiment.

The light source constituted from these modules 5 to 7 is the same as the above-mentioned light source of the present embodiment.

[4. Advantageous effect]

According to the light source of the present embodiment, a desired irradiated surface can be irradiated with a homogenized-colored light having high color rendering, with high luminous efficiency.

Furthermore, in a conventional synthetic light source using a Blue-LED, red color component was always weak for color rendering due to the lack of red color component in the synthesized light, because white color composed of complementary colors was made using yellow. On the contrary, the light source of the present embodiment can improve color rendering because it can use versatile colors of lights as primary light.

In addition, in a conventional synthetic light source using a near-UV LED, combined with mixed phosphors of such colors as blue, green and red, luminous efficiency was sometimes not sufficiently high, due to the absorption of fluorescence emitted from blue or green phosphor by red phosphor, or due to the deprivation of energy by red phosphor, having particularly bad light-conversion efficiency, which is induced when exciting red, orange, yellow and green phosphors by blue phosphor, excited by the near-UV LED (namely, induced by the double excitation structure). On the contrary, in the light source of the present embodiment, the luminous efficiency can be expected to be dramatically improved because any primary light source can be used without any restriction on the kind of the primary light source.

In addition, a conventional light source using a PDP does not have sufficient luminance, just around 100 to 60 candela/m$^2$, for the use as lighting system. On the contrary, in the light source of the present embodiment, sufficient luminance can be obtained by optimizing the kinds of the primary light sources. Consequently, the light source of the present embodiment can be used for many purposes.

Furthermore, the light source of the present embodiment can be constituted rigidly by using the light-emitting solid device. Therefore, it is not vulnerable to physical sabotage, unlike a fluorescent lamp.

In addition, a conventional fluorescent lamp is, as it uses mercury, desired to be substituted by the other kind of light source from the standpoint of environmental influence. On the contrary, the light source of the present embodiment can be utilized as a light source having capabilities equal to or better than those of a fluorescent lamp, and furthermore can prevent the improper influence to the environment.

Furthermore, a conventional multipoint light source formed by just arranging LEDs has inferior color rendering, because the spectra of the LEDs are too sharp, or particularly because there is a positive correlation between improvement of LED's crystalline quality leading to improvement of luminous efficiency and sharpness of the spectrum, thereby the use of it is limited to character display or the like. On the contrary, in the light source of the present embodiment, as the spectrum of the primary light source is not restricted, the primary light having broader spectrum than before can be used. Consequently, the synthesized light having enhanced color rendering can be obtained, leading to the possibility of application to such wide range of use as not only character display but also lighting system, image display and so on.

And according to a light-emitting solid device module, phosphor module and illuminance-distribution element module of the present embodiment, component-by-component replacement of the light source of the present embodiment can be realized. This makes possible reduction in running cost of the light source of the present embodiment, as well as simplification in disposal of the light source and other components of the present embodiment at the time of their disposal.

Furthermore, the above-mentioned modularization is useful, not only when the components of the present embodiment come to the end of lifetime but also when they are replaced by the ones having better capabilities. For example, when a light-emitting solid device of old type is to be replaced by a light emitting device of new type, only the one actually to be replaced can be removed and replaced thanks to the above-mentioned modularization. Consequently, this also makes possible reduction in the running cost of the light source of the present embodiment.

Incidentally, as an example of light-emitting solid device 2 can be cited an LED. However, LEOs are generally more expensive and longer in lifetime than phosphors. Therefore, it is very useful, from the standpoint of cost, to modularize LED and phosphor separately with respect to lifetime and separate their industrial cycle.

[II. Method for controlling light]

In the above-mentioned light source of the present embodiment, the light emitted from the light source of the present embodiment can be controlled either by replacing the primary light source or by providing the primary-light controller capable of controlling at least a part of the amount of the primary lights by controlling the primary light sources. By controlling light, the color as well as the color temperature of the synthesized light can be controlled.

In the following, the respective light sources of the present embodiment, wherein the light can be controlled, will be explained.

[1. Light control by replacing primary light source]

The light emitted from the light source of the present invention can be controlled by means of replacing the primary light source appropriately in a manner that the maximum value among differences between each of CIE chromaticity coordinates of the primary lights is kept within the above-mentioned range and the primary lights are kept to have the same illuminance distribution characteristics to the extent that the color of the synthesized light is homogenized at the desired irradiated surface, for the purpose of making light, having the intended color or color temperature, emit from the light source of the present embodiment. For example, in order to control the color temperature of the synthesized light by light control, the light control can be done with the aid of such feature that, color temperature will rise as the intensity of the light with relatively short wavelength among the primary lights which are constituting the synthesized light gets stronger, and that it will decrease as the intensity of the light with relatively long wavelength among the same primary lights gets stronger.

Fig. 6 is a schematic exploded perspective view illustrating an example of the light source where light is controlled by the replacement. However, it is to be noted that the following example is by no means restrictive and any modifications can be added thereto insofar as they do not depart from the scope of the present invention. In Fig. 6, components designated by the same reference numerals as in Figs. 2 to 5 are the same as those of Figs. 2 to 5.

As shown in Fig. 6, this light source comprises light-emitting solid device module 5, turntable 8 having phosphor modules 6, 6', and illuminance-distribution element module 7.

Light-emitting solid device module 5 is constructed in such manner as to comprise four LEDs, as light-emitting solid devices 2, at base 51 and be able to supply electric power through wiring 52 formed on base 51 for emitting light.

Turntable 8 comprises phosphor module 6 and phosphor module 6'. The rotation of turntable 8 makes either phosphor module 6 or phosphor module 6' dispose between light-emitting solid device 5 and illuminance-distribution element module 7. Thereby the fluorescence emitted by that phosphor modules 6, 6' can be used as primary light.

Phosphor module 6 is constructed in such manner as to comprise four phosphor sections 3 at base 61. Every phosphor section 3 receives lights from light-emitting solid devices 2 at the back side and emits fluorescence to the front side as primary light. In addition, in this example, phosphor section 3 contains phosphors emitting red or orange, yellow, green, and blue fluorescences, with the maximum value among differences between each of CIE chromaticity coordinates of the color of the fluorescences (primary lights), emitted from each phosphor section 3, kept within the above-mentioned range.

Phosphor module 6' is constructed in similar manner to phosphor module 6, namely it comprises four phosphor sections 3' at base 61'. Every phosphor section 3' receives lights from light-emitting solid devices 2 at the back side and emits fluorescence to the front side as primary light. In addition, phosphor section 3' also contains phosphors emitting red or orange, yellow, green, and blue fluorescences.

However, phosphor section 3' of phosphor module 6' contains more amount of orange and yellow phosphors and less amount of blue phosphors, compared to phosphor section 3 of phosphor module 6.

Illuminance-distribution element module 7 is constructed in such manner as to comprise four lens at base 71, as illuminance-distribution controlling elements 4. The illuminance distribution characteristics of the fluorescence emitted from respective phosphor sections 3, 3' is equalized by passing through the lens to the extent as described above.

This type of light source is constructed as above. Consequently, light emitted from light-emitting solid device 2 makes phosphors within phosphor sections 3, 3', formed in phosphor modules 6, 6', emit light, and then the fluorescence emitted is used as primary light. In this case, when the above primary light changes, the color temperature thereof will also change, on the ground that the synthesized light is made by synthesizing fluorescences emitted from phosphor sections 3, 3'. Specifically, when the rotation of turntable 8 makes phosphor module 6 disposed between light-emitting solid device 5 and illuminance-distribution element module 7, the synthesized light having relatively high color temperature is obtained. On the contrary, when phosphor module 6 is disposed between light-emitting solid device 5 and illuminance-distribution element module 7, the synthesized light having relatively low color temperature is obtained. With this construction, light control which enables control of the color temperature of the synthesized light, which is emitted from this type of light source, can be carried out, by replacing phosphor module 6 with phosphor module 6', namely replacing phosphor section 3 for phosphor section 3', using turntable 8. By adopting such construction as above, one lighting system can be used by switching it between day and night. For example, in the daytime, a neutral fluorescent color light with color temperature of 5000 K or a daylight color light with color temperature of 6500 K can be used for ease in desk work or the like by using phosphor module 6. And at night, a light-bulb color light with color temperature of 2850 K can be used for relaxation by using phosphor module 6'.

[2. Light control by primary-light controller]

The light emitted from the light source of the present embodiment can be controlled, by means of providing the primary-light controller capable of controlling at least a part of the amount of the primary light to the light source of the present embodiment for controlling the primary light sources, in a manner that the maximum value among differences between each of CIE chromaticity coordinates of the primary lights is kept within the above-mentioned range and the primary lights are kept to have the same illuminance distribution characteristics to the extent that the color of the synthesized light is homogenized at the desired irradiated surface, for the purpose of making light, having the intended color or color temperature, emit from the light source of the present embodiment. For example, in order to control the color temperature of the synthesized light by light control, such as controlling the amount of light of the light-emitting solid device, the light control can be done, similarly to the above example of light control by means of the replacement, with the aid of such feature that, color temperature will rise as the intensity of the light with relatively short wavelength among the primary lights which are constituting the synthesized light gets stronger, and that it will decrease as the intensity of the light with relatively long wavelength among the same primary lights gets stronger.

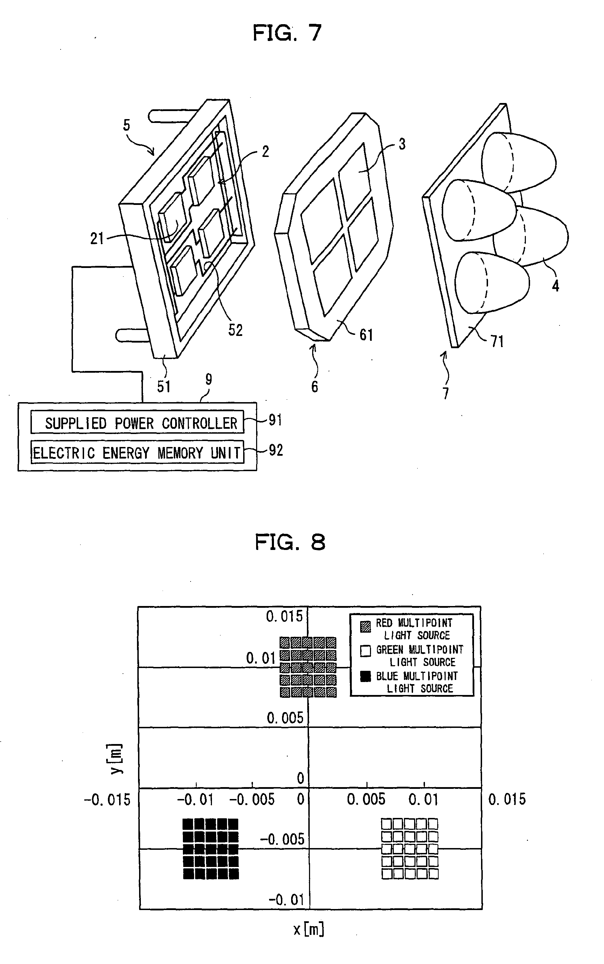

Fig. 7 is a schematic exploded perspective view illustrating an example of the light source where light is controlled by the primary-light controller. However, it is to be noted that the following example is by no means restrictive and any modifications can be added thereto insofar as they do not depart from the scope of the present invention. In Fig. 7, components designated by the same reference numerals as in Figs. 2 to 6 are the same as those of Figs. 2 to 6.

As shown in Fig. 7, this light source comprises light-emitting solid device module 5, phosphor modules 6, illuminance-distribution element module 7 and primary-light controller 9.

Light-emitting solid device module 5 is constructed in such manner as to comprise four LEDs, as light-emitting solid devices 2, at base 51 and be able to supply electric power through wiring 52 formed on base 51 for emitting light.

Phosphor module 6 is constructed in such manner as to comprise four phosphor sections 3 at base 61. Every phosphor section 3 receives lights from light-emitting solid devices 2 at the back side and emits fluorescence to the front side as primary light. In addition, in this example, it is assumed that phosphor section 3 contains phosphors emitting red or orange, yellow, green, and blue fluorescences, with the maximum value among differences between each of CIE chromaticity coordinates of the color of the fluorescences (primary lights), emitted from each phosphor section 3, kept within the above-mentioned range.

Illuminance-distribution element module 7 is constructed in such manner as to comprise four lens at base 71, as illuminance-distribution controlling elements 4. The illuminance distribution characteristics of the fluorescence emitted from respective phosphor sections 3 is equalized by passing through the lens to the extent as described above.

Primary-light controller 9 comprises supplied power controller 91 and electric energy memory unit 92.

Supplied power controller 91 is such constructed as to read, according to the direction to change the color temperature of the synthesized light emitted from this light source from outside by a switch (not shown in the figures) for example, the information of electric power supplied, corresponding to the direction from electric energy memory unit 92, and to control the amount of electric power supplied to light-emitting solid device 2, which is disposed on light-emitting solid device module 5, following the information of electric power supplied.

In electric energy memory unit 92, the color temperature and the amount of electric power which should be supplied to each light-emitting solid device 2 depending on its color temperature are stored as information of electric power supplied. The specific value of the information of electric power supplied may be, for example, calculated experimentally and stored in advance.

It is assumed in this example, in order to raise the color temperature, electric power supplied to light-emitting solid device 2, which supplies excitation light to phosphor section 3 that emits relatively short wavelength fluorescence (for example, blue fluorescence), should be increased, as well as electric power supplied to light-emitting solid device 2, which supplies excitation light to phosphor section 3 that emits relatively long wavelength fluorescence (for example, orange fluorescence), should be decreased, by the control of supplied power controller 91. On the contrary, it is assumed in this example, in order to lower the color temperature, electric power supplied to light-emitting solid device 2, which supplies excitation light to phosphor section 3 that emits relatively short wavelength fluorescence (for example, blue fluorescence), should be decreased, as well as electric power supplied to light-emitting solid device 2, which supplies excitation light to phosphor section 3 that emits relatively long wavelength fluorescence (for example, orange fluorescence), should be increased, by the control of supplied power controller 91.

The hardware of primary-light controller 9, in this example, consists of CPU (Central Processing Unit), memory such as RAM (Random Access memory) and ROM (Read Only Memory), interface such as analog-digital converter or the like. Primary-light controller 9 is assumed to be constructed such that these CPU, memory, interface and the like function as above-mentioned electric supplied power controller 91 and electric energy memory unit 92.

This type of light source is constructed as above. Consequently, light emitted from light-emitting solid device 2 makes phosphors within phosphor sections 3, formed in phosphor modules 6, emit light, and then the fluorescence emitted is used as primary light. In this case, when the above primary light changes, the color temperature thereof will also change, on the ground that the synthesized light is made by synthesizing fluorescences emitted from phosphor sections 3. Specifically, the electric power supplied to light-emitting solid device 2 and the light amount of the excitation light supplied to each phosphor section 3 can be controlled, thereby control of the light amount of the primary light with each wavelength being enabled. With this construction, light control which enables control of the color temperature of the synthesized light, which is emitted from this type of light source, can be carried out, by controlling the light amount of the primary light, using primary-light controller 9. In other words, the color temperature of the synthesized light can be lowered by such control as to decrease the electric power supplied to light-emitting solid device 2 corresponding to phosphor section 3, which emits blue fluorescence, and as to increase the electric power supplied to light-emitting solid device 2 corresponding to phosphor section 3, which emits orange fluorescence. On the contrary, the color temperature of the synthesized light can be heightened by such control as to increase the electric power supplied to light-emitting solid device 2 corresponding to phosphor section 3, which emits blue fluorescence, and as to decrease the electric power supplied to light-emitting solid device 2 corresponding to phosphor section 3, which emits orange fluorescence.

As primary-light controller 9 can be used: PWM circuit, pulse-frequency modulation (hereinafter referred to as "PFM" as appropriate) circuit, or pulse-amplitude modulation (hereinafter referred to as "PFM" as appropriate) circuit, for example. Other than such pulse-digital circuits as PWM, PFM and PAM, analogue circuits such as operational amplifier can be also used. In addition, an impedance circuit can be also applied.

[3. Advantageous effect]

According to the method for controlling light and light source of the present embodiment as described above, the color temperature of the synthesized light emitted can be controlled continuously and freely.

Furthermore, according to the method for controlling light and light source of the present embodiment as described above, even the chromaticity outside of blackbody radiation locus can be controlled continuously and freely, which can not be controlled even with a filament lamp.

In addition, in the conventional light sources such as the ones in CRT, PDP, EL, OEL and OLED, essential power for the light source, which enable light control by lighting system level. However, according to the method for controlling light and light source of the present embodiment as described above, such problem of insufficient power for light source can be resolved, thereby a stable light control being enabled.

The method for controlling light and the light-controllable light source as described above are imposed with no specific limitation, and can be applied to any light sources using primary light sources with different wavelengths, insofar as the primary lights are changed in a manner that the maximum value among differences between each of CIE chromaticity coordinates of the primary lights is kept to be within the above-mentioned range, namely 0.05 or larger, and the primary lights are kept to have the same illuminance distribution characteristics to the extent that the color of the synthesized light is homogenized at a desired irradiated surface.

[III. Lighting system]

The light source of the present embodiment, as described above, can be used as lighting system, for example.

By using the above-mentioned light source as lighting system, a lighting system having nonconventional, new function of color-temperature variability can be proposed. Furthermore, in that lighting system, the same advantageous effects mentioned above as described for the explanation on the light source and the components thereof such as light-emitting solid device module, phosphor module and illuminance-distribution element module, of the present embodiment, can be obtained.

In addition, compared to a fluorescent lamp, one of the conventional lighting system, the lighting system using the light source of the present embodiment can achieve the color-temperature variability by just one light source, though a fluorescent lamp has a problem of emitting only white light with fixed, predetermined color temperature.

Furthermore, the lighting system of the present embodiment can be miniaturized as a lighting system than a fluorescent lamp, thereby the distance to the irradiated surface, which can be irradiated with light of homogenized color, can be shortened.

Furthermore, the lighting system of the present embodiment show the following advantage, compared to the conventional synthetic light source, combining LED and phosphor. Namely, the conventional synthetic light source can not realize color-temperature variability, as it is constructed in a manner that the mixture ratio of the phosphors is set to fix one chromaticity point, similar to fluorescent lamps. And the conventional synthetic light source costs high, as it is constructed so that LED and phosphor are integrated, leading to the problem that lifetime of the entire light source depends on the characteristics of the phosphor. On the contrary, according to the lighting system using the light source of the present embodiment, these problems can be resolved.

Furthermore, the lighting system using the light source of the present embodiment can realize a lighting system superior to the conventional ones in terms of luminous efficiency, lifetime, color rendering or the like.

[IV. Display]

The light source of the present embodiment as described above can be also used as display, for example.

By using the above-mentioned light source as display, advantageous effects such as improvement in luminous efficiency, electric-power saving, expanded range of color reproduction and realization of large-size display can be achieved, in addition to the same advantageous effects of the above-mentioned light source of the present embodiment.

In addition, compared to the conventional display using CRT, using the light source of the present embodiment can make the display formed thinner, and also realize electric-power saving.

In addition, compared to the conventional display using PDP, using the light source of the present embodiment for a display can realize energy saving, as well as improvement in endurance for physical sabotage. Further, as PDP is usually an emission mechanism with larger Stokes' shift than a fluorescent lamp or the like, physical limit of the improvement in luminous efficiency was severe. But with the technology of the present embodiment, the above-mentioned physical limit of the improvement in luminous efficiency can be overcome. Furthermore, the emission intensity of the lighting system using PDP can be enhanced.

In addition, in the conventional display using OEL or OLED, when organic dye comes to the end of its lifetime, which is often short, it can not be replaced separately, because that kind of conventional display has laminated and integrated structure, leading to high cost for the replacement. However, by using the light source of the present embodiment for a display, components of the display can be replaced separately, and therefore there is no possibility of the above-mentioned problem of high cost.

In addition, the conventional display using OEL or OLED tends to have low emission intensity. However, by using the light source of the present embodiment for a display, this problem can also be overcome.

In addition, in the conventional LED display, it was very complicated to repair it when it had a pixel defect. On the contrary, when a display is constructed using the light source of the present embodiment, the pixel defect can be repaired easily.

Furthermore, when the display using the light source of the present invention is shifted its mode for a lighting system, its range of color reproduction can be expanded than the conventional LED display.

In addition, as the conventional emission materials such as AlInGaP:Red-LED, InGaN:Green-LED and InGaN: Blue-LED are usually used for producing LEDs with each MOCVD growth furnace, the process lines, as a whole, comes to be very complicated and expensive. However, the display using the light source of the present invention can make the entire development cost inexpensive and the process line simple, by, for example, researching just one process line of near ultraviolet InGaN-LED, which is an excitation source, intensively and developing low-cost mass-production system, in which an inexpensive phosphor is combined.

[V. Others]

Although an embodiment of the present invention has been explained, it is to be noted that this embodiment is by no means restrictive and any modifications can be added thereto, insofar as they do not depart from the scope of the present invention.

For example, it is possible to combine arbitrary the above described components such as light source, light-emitting solid device module, phosphor module, illuminance-distribution element module, as well as components of the lighting system and display, insofar as the advantage of the present invention is not significantly impaired.

[Example]

The present invention will be explained more concretely below by referring to examples. However, the present invention is not limited to these examples and any modification can be added thereto insofar as it does not depart from the scope of the present invention.

[Example 1]

By the following configuration, a light source consisting of primary light sources each of which emits red, green and blue primary light was assumed. Whether the synthesized light emitted from the light source, assumed to irradiate the irradiated surface, is homogenized at the irradiated surface or not was estimated by a calculation.

Each primary light source, which emits red, green, and blue, was made of a multipoint light source, the emission surface of which, having square shape of 5 mm x 5 mm, was divided into 25 of smaller, 1 mm x 1 mm squares. These primary light sources were set to be located at each apex of an equilateral triangle on a plane. Each CIE chromaticity coordinate calculated, of these hypothetical light sources, was as follows. Red multipoint light source was of (0.691,0.309), green multipoint light source was of (0.238,0.733), and blue multipoint light source was of (0.118, 0.076).

The distance between each center of the primary light sources and the center of the above-mentioned equilateral triangle was set to measure 1 cm. Fig. 8 is a schematic drawing of an arrangement of the primary light sources.

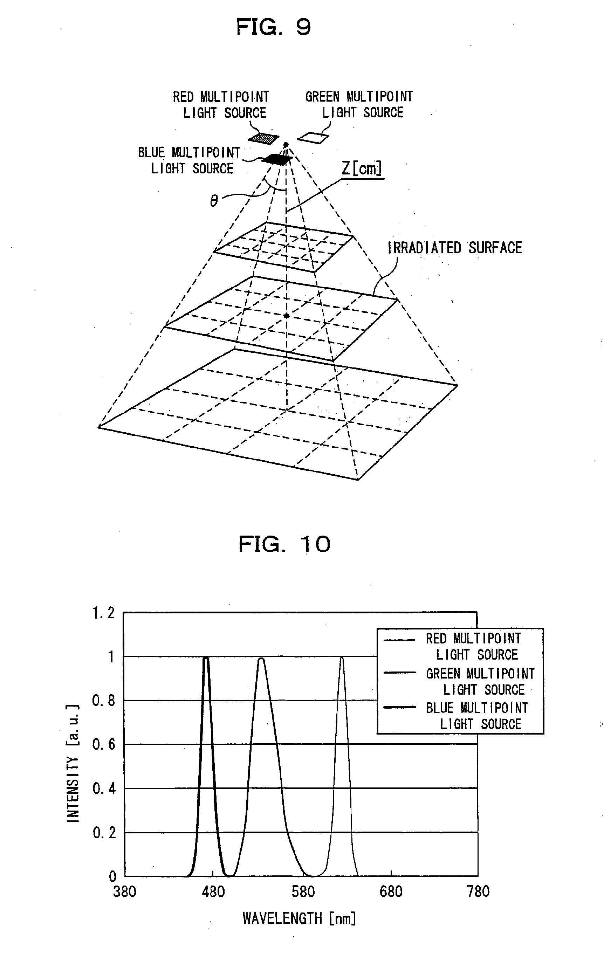

A plane, which is parallel to the plane assumed to be located with the above-mentioned primary light sources, and whose distance from the above-mentioned plane is Z cm was decided to be the irradiated surface, which was irradiated with the synthesized light from the light source consisting of the above-mentioned primary light sources. Fig. 9 shows the relation between the irradiated surface and the primary light sources schematically.

In this example, it is assumed that, as primary light source emitting a red primary light (hereinafter referred to as "red multipoint light source" as appropriate), was used a red LED using InAlGaAs, as primary light source emitting a green primary light (hereinafter referred to as "green multipoint light source" as appropriate), was Used a green LED using InGaN, and as primary light source emitting a blue primary light (hereinafter referred to as "blue multipoint light source" as appropriate), was used a blue LED using InGaN. Fig. 10 shows respective spectra of red multipoint light source, green multipoint light source and blue multipoint light source.

In addition to the above assumption, it is assumed the illuminance distribution characteristics of the primary lights, emitted from each of the red multipoint light source, green multipoint light source and blue multipoint light source, are equalized. And then, the pattern formed on the irradiated surface, illuminated by the synthesized light, and the CIE chromaticity coordinates at the predetermined points on the irradiated surface were calculated, in each case of the distance Z, between the light source and irradiated surface, is 10 cm or 250 cm. At this point, CIE chromaticity coordinates were calculated by the chromaticity at points on a line segment, which had a predetermined length and was drawn in a certain direction from a point, at which a normal line, descending from the center of the equilateral triangle assumed to be disposed with the above-mentioned primary light sources, crossed with the irradiated surface. In this example, the length of the above line segment is set to be 10 cm when the irradiated surface had Z equal to 10 cm, and 250 cm when the irradiated surface had Z equal to 250 cm.

In addition, in Example 1, the intensities of the primary lights in $\Phi$ direction, of respective red multipoint light source, green multipoint light source and blue multipoint light source, were set to be identical, and the illuminance distribution characteristics of the primary light sources were set to be equalized by the fact that every intensity of the primary lights in $\theta$ direction:

$$I_{Shape}(\theta)$$

could be calculated by:

$$I_{Shape}(\theta) = \frac{1}{9+1}\left(9 \times \cos^{80}\theta + 1 \times \cos^{10}\theta\right)$$

Incidentally, by judging the above-mentioned condition (A) with respect to the illuminance-distribution characteristics, all these values equal to zero.

By Using these relations, radiation calculation for the multipoint light source was carried out. The radiation calculation for the multipoint light source is as follows.

$$E_R(\vec{r}_D(x_D, y_D), \lambda) = I_{R0\_RED} \times S_{RED}(\lambda) \times \sum_{i=1}^{5}\sum_{j=1}^{5}\left(I_{RED\atop Shape}(\theta_{ij})\frac{\cos\delta_{RED\_ij}}{|\vec{r}_D(x_D, y_D) - \vec{r}_{S\_RED\_ij}|^2}\right)$$
$$+ I_{R0\_GREEN} \times S_{GREEN}(\lambda) \times \sum_{i=1}^{5}\sum_{j=1}^{5}\left(I_{GREEN\atop Shape}(\theta_{ij})\frac{\cos\delta_{GREEN\_ij}}{|\vec{r}_D(x_D, y_D) - \vec{r}_{S\_GREEN\_ij}|^2}\right)$$
$$+ I_{R0\_BLUE} \times S_{BLUE}(\lambda) \times \sum_{i=1}^{5}\sum_{j=1}^{5}\left(I_{BLUE\atop Shape}(\theta_{ij})\frac{\cos\delta_{BLUE\_ij}}{|\vec{r}_D(x_D, y_D) - \vec{r}_{S\_BLUE\_ij}|^2}\right)$$

In the formula, $I_{R0\_RED}$, $I_{R0\_GREEN}$, $I_{R0\_BLUE}$, $S_{RED}(\lambda)$, $S_{GREEN}(\lambda)$ and $S_{BLUE}(\lambda)$ indicate emission intensity constants and spectra of respective red, green and blue multipoint light sources, respectively. For example, the term for the calculation of red multipoint light source in the above formula:

$$\frac{\cos \delta_{RED\_ij}}{\mid \vec{r}_D(x_D, y_D) - \vec{r}_{S\_RED\_ij} \mid^2}$$

is a factor for the calculation of light intensity attenuation by a change of the distance between the light source and irradiated surface in a three-dimensional space.

These constant values and calculated values are determined by calculation, each time when the spectrum intensity, spatial relationship between the location and the surface to be measured or the like are determined. They are important parameters, but secondary-main factors.

Compared to these terms, which are high in constancy, changes of the normalized illuminance distributions:

$$I_{RED \atop Shape}(\theta) \, , \, I_{GREEN \atop Shape}(\theta) \, , \, I_{BLUE \atop Shape}(\theta)$$

affects significantly the calculated value.

With these mathematical formulae, the irradiahces at X-Y plane were calculated, by which then the CIE chromaticity coordinates were calculated.

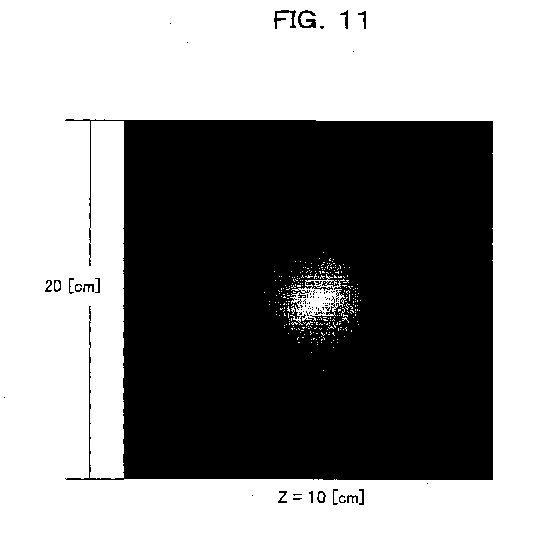

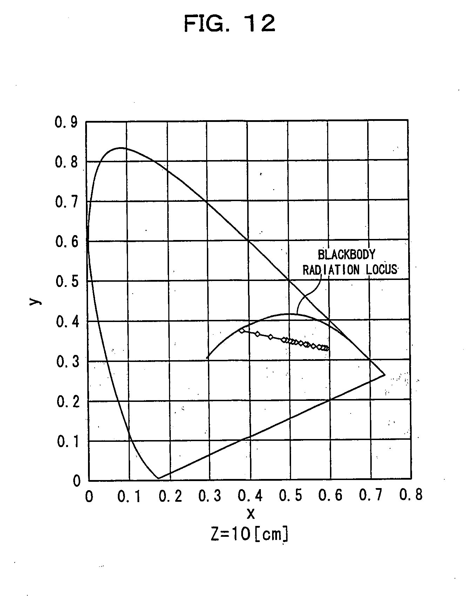

Fig. 11 shows the pattern on the irradiated surface of Z = 10 cm, obtained from the calculation. Fig. 12 is a drawing of the CIE chromaticity coordinates obtained from the calculation for this irradiated surface, plotted on the CIE chromaticity diagram (the range of which is x = 0, Y = 0 to 10 cm). The location of the line segment on which the chromaticity was calculated is shown by dashed line, in Fig. 11.

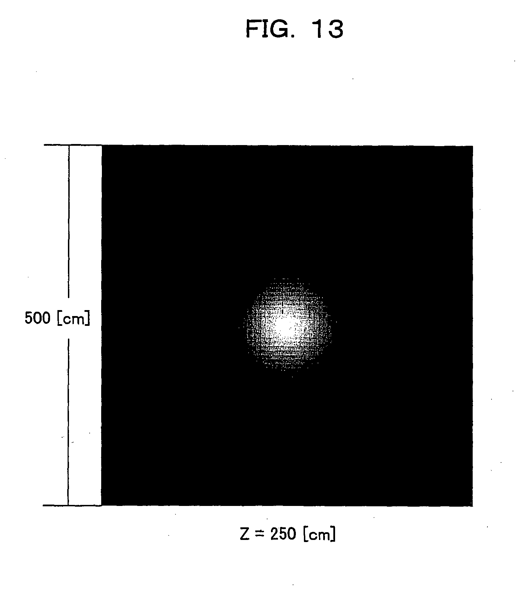

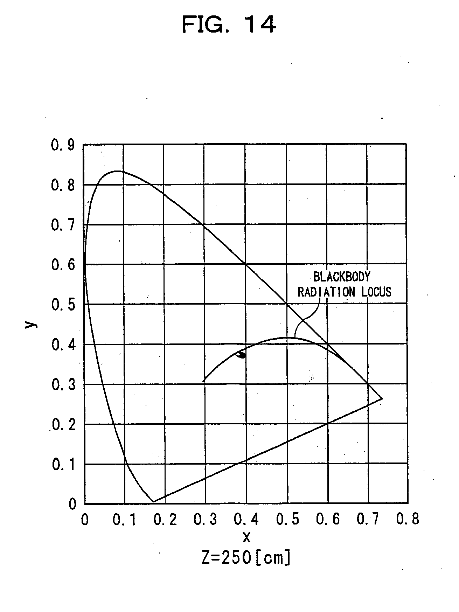

Fig. 13 shows the pattern on the irradiated surface of Z = 250 cm, obtained from the calculation. Fig. 14 is a drawing of the CIE chromaticity coordinates obtained from the calculation for this irradiated surface, plotted on the CIE chromaticity diagram (the range of which is x = 0, Y = 0 to 250 cm). The location of the line segment on which the chromaticity was calculated is shown by dashed line, in Fig. 13.

From these results, it was confirmed that the CIE chromaticity coordinates were changed depending on the position of the irradiated surface and therefore the color of the synthesized light was not homogenized at the irradiated surface of Z = 10 cm, and that the CIE chromaticity coordinates were constant over the whole irradiated surface and therefore the color of the synthesized light was homogenized at the irradiated surface of Z = 250 cm.

[Example 2]

Whether the synthesized light was homogenized or not at the irradiated surface was estimated, by the same method as Example 1, other than that the illuminance distribution characteristics of the primary light sources were set to be equalized by the fact that every intensity of the primary lights in θ direction:

$$I_{Shape}(\theta)$$

could be calculated by:

$$I_{Shape}(\theta) = \frac{1}{9+1}\left(9 \times \cos^{20}\theta + 1 \times \cos^{3}\theta\right)$$

Incidentally, by judging the above-mentioned condition (A) with respect to the illuminance distribution characteristics, all these values equal to zero.

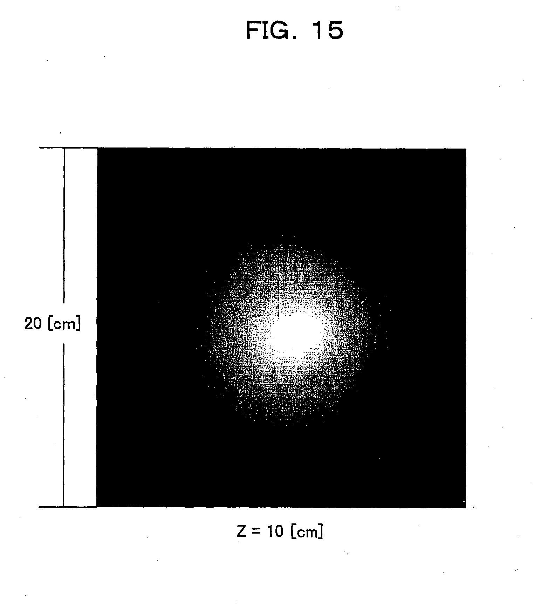

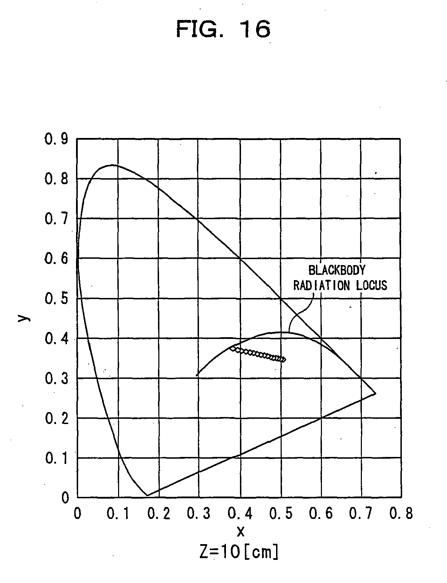

Fig. 15 shows the pattern on the irradiated surface of Z = 10 cm, obtained from the calculation. Fig. 16 is a drawing of the CIE chromaticity coordinates obtained from the calculation for this irradiated surface, plotted on the CIE chromaticity diagram (the range of which is x = 0, Y = 0 to 10 cm). The location of the line segment on which the chromaticity was calculated is shown by dashed line, in Fig. 15.

## EP 1 876 387 A1

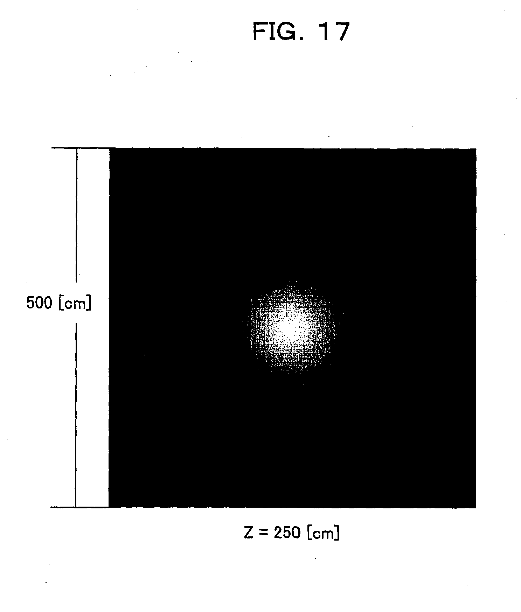

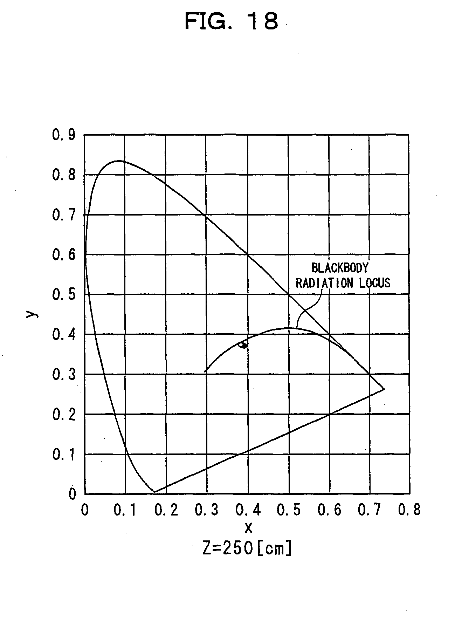

Fig. 17 shows the pattern on the irradiated surface of Z = 250 cm, obtained from the calculation. Fig. 18 is a drawing of the CIE chromaticity coordinates obtained from the calculation for this irradiated surface, plotted on the CIE chromaticity diagram (the range of which is x = 0, Y = 0 to 250 cm).The location of the line segment on which the chromaticity was calculated is shown by dashed line, in Fig. 17.

From these results, it was confirmed that the CIE chromaticity coordinates were changed depending on the position of the irradiated surface and the color of the synthesized light was not homogenized at the irradiated surface of Z=10 cm, and that the CIE chromaticity coordinates were constant over the whole irradiated surface and the color of the synthesized light was homogenized at the irradiated surface of Z = 250 cm.

[Example 3]

Whether the synthesized light was homogenized or not at the irradiated surface was estimated, by the same method as Example 1, other than that the illuminance distribution characteristics of the primary light sources were set to be equalized by the fact that each primary light emitted came to be a Lambert distribution of light. Incidentally, by judging the above-mentioned condition (A) with respect to the illuminance distribution characteristics, all these values equal to zero.

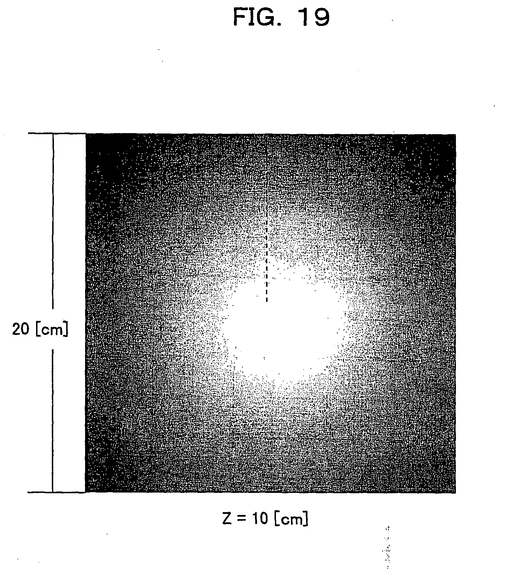

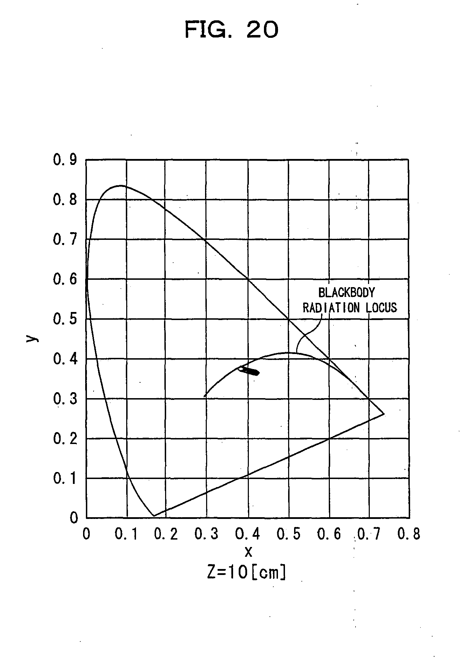

Fig. 19 shows the pattern on the irradiated surface of Z = 10 cm, obtained from the calculation. Fig. 20 is a drawing of the CIE chromaticity coordinates obtained from the calculation for this irradiated surface, plotted on the CIE chromaticity diagram (the range of which is x = 0, Y = 0 to 10 cm).The location of the line segment on which the chromaticity was calculated is shown by dashed line, in Fig. 19.

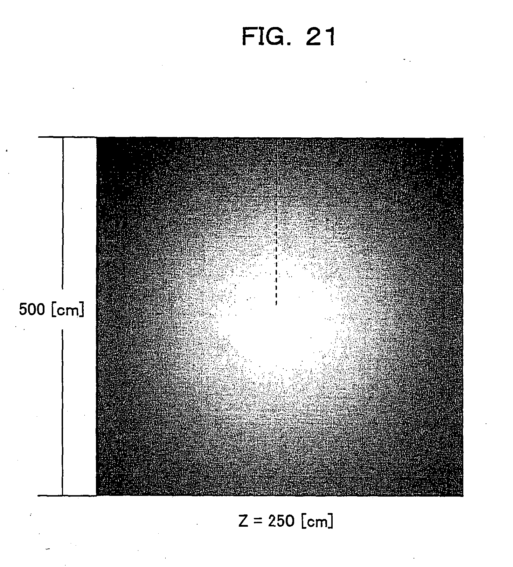

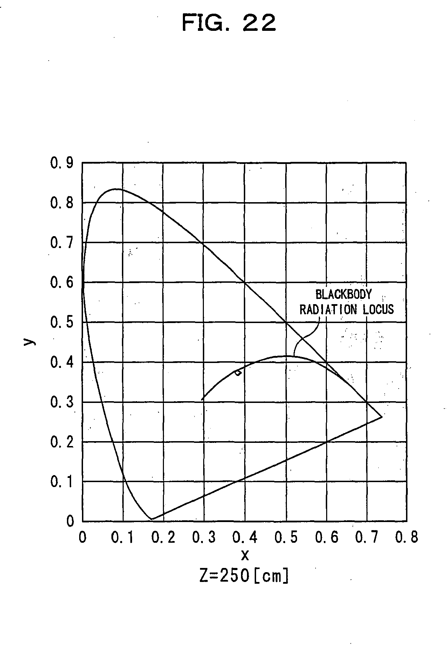

Fig. 21 shows the pattern on the irradiated surface of Z = 250 cm, obtained from the calculation. Fig. 22 is a drawing of the CIE chromaticity coordinates obtained from the calculation for this irradiated surface, plotted on the CIE chromaticity diagram (the range of which is x = 0, Y = 0 to 250 cm).The location of the line segment on which the chromaticity was calculated is shown by dashed line, in Fig. 21.

From these results, it was confirmed that the CIE chromaticity coordinates were changed depending on the position of the irradiated surface and the color of the synthesized light was not homogenized at the irradiated surface of Z = 10 cm, and that the CIE chromaticity coordinates were constant over the whole irradiated surface and the color of the synthesized light was homogenized at the irradiated surface of Z = 250 cm.

[Comparative Example 1]

Whether the synthesized light was homogenized or not at the irradiated surface was estimated, by the same method as Example 1, other than that the illuminance distribution characteristics of the primary light sources were set to be not equalized by the fact that the intensity of the red multipoint light source:

$$I_{red \atop Shape}(\theta)$$

intensity of the green multipoint light source:

$$I_{green \atop Shape}(\theta)$$

and intensity of the blue multipoint light source:

$$I_{blue \atop Shape}(\theta)$$

, which are the primary light sources, could be calculated as

$$I_{\substack{red \\ Shape}}(\theta) = \frac{1}{35+5}\left(35 \times \cos^{40}\theta + 5 \times \cos^{3}\theta\right)$$

$$I_{\substack{green \\ Shape}}(\theta) = \frac{1}{20+15}\left(20 \times \cos^{70}\theta + 15 \times \cos^{10}\theta\right)$$

$$I_{\substack{blue \\ Shape}}(\theta) = \frac{1}{20+8}\left(20 \times \cos^{80}\theta + 8 \times \cos^{6}\theta\right)$$

Incidentally, by judging the above-mentioned condition (A) with respect to the illuminance distribution characteristics, the maximum difference between those of the primary lights from red multipoint light source and green multipoint light source is $\Delta I = 0.062$, the maximum difference between those of the primary lights from green multipoint light source and blue multipoint light source is $\Delta I = 0.094$, and the maximum difference between those of the primary lights from blue multipoint light source and red multipoint light source is $\Delta I = 0.123$.

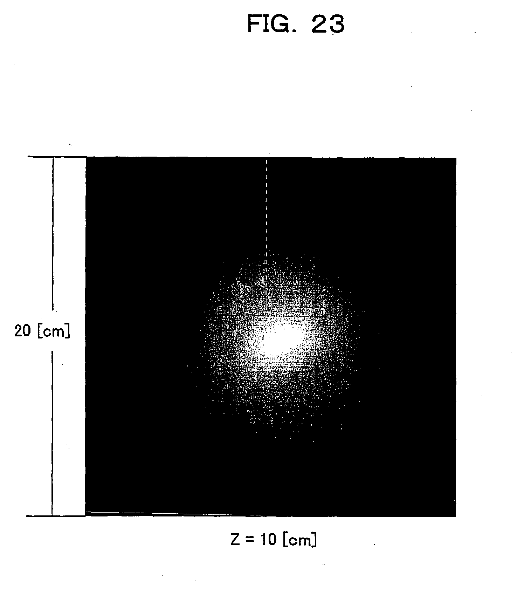

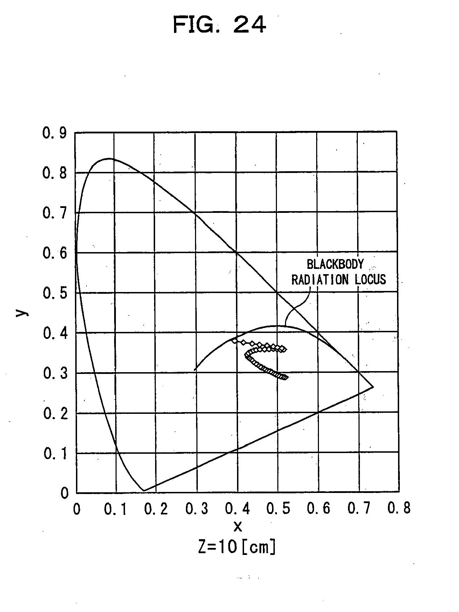

Fig. 23 shows the pattern on the irradiated surface of Z = 10 cm, obtained from the calculation. Fig. 24 is a drawing of the CIE chromaticity coordinates obtained from the calculation for this irradiated surface, plotted on the CIE chromaticity diagram (the range of which is x = 0, Y = 0 to 10 cm). The location of the line segment on which the chromaticity was calculated is shown by dashed line, in Fig. 23.

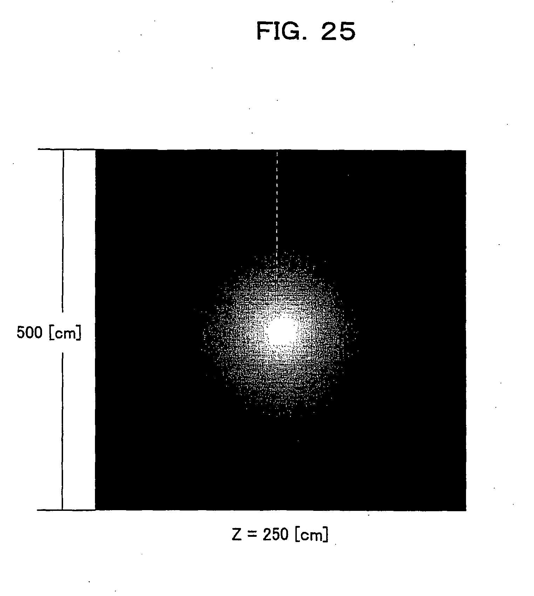

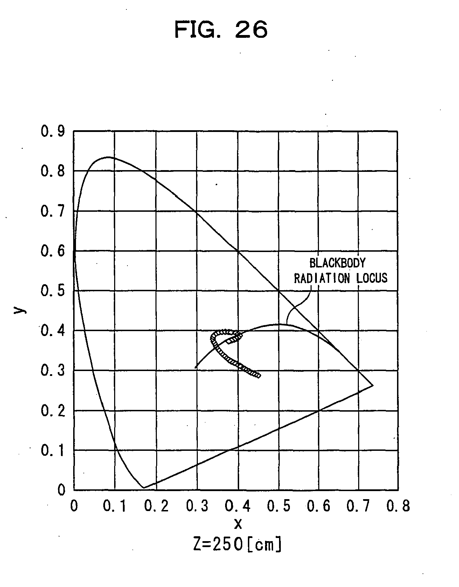

Fig. 25 shows the pattern on the irradiated surface of Z = 250 cm, obtained from the calculation. Fig. 26 is a drawing of the CIE chromaticity coordinates obtained from the calculation for this irradiated surface, plotted on the CIE chromaticity diagram (the range of which is x = 0, Y = 0 to 250 cm). The location of the line segment on which the chromaticity was calculated is shown by dashed line, in Fig. 25.

From these results, it was confirmed that the CIE chromaticity coordinates were changed depending on the position of the irradiated surface and the color of the synthesized light was not homogenized either at the irradiated surface of Z = 10 cm or at the irradiated surface of Z = 250 cm.

[Example 4]

Four kinds of phosphors, all of which include equal to or more than 10 weight % of particles with median particle size of 5 to 10 $\mu$m and particle diameter of 5 $\mu$m or smaller, were coated one by one, using 500 mg of epoxy resin respectively, on a light emitting device, based on surface-mount type of InGaN semiconductor with excitation peak wavelength of 399 nm. The four kinds of phosphors were: 92 mg of blue phosphor $(Sr,Ca,Ba,Mg)_{10}(PO_4)_6(Cl,F)_2{:}Eu$, 92 mg of green phosphor (Zn,Cd)S:Cu,Al, 98 mg of yellow phosphor (Zn,Cd)S:Au,Al, and compound of 23 mg of orange phosphor (Zn,Cd)S:Ag,Cl with 297 mg of red phosphor. Surface-mount LEDs, emitting primary lights of Lambert distribution (namely, the illuminance distribution characteristics are identical), of which CIE chromaticity coordinates are (0.163,0.129) (blue), (0.322,0.599) (green), (0.482,0.508) (yellow) and (0.562,0.434) (orange-red), were disposed on the same basal plate at the same angles, with their center positions at 2.2 cm intervals. Each phosphor section was formed to be approximately rectangular shape having dimension of 1.4 cm x 1.5 cm x 0.45 mm.

The measurement of luminance as a light source, for each phosphor, is as follows. The average luminance and peak luminance of the blue phosphor was 436 candela/m$^2$ and 701 candela/m$^2$ respectively. The average luminance and peak luminance of the green phosphor was 1075 candela/m$^2$ and 2489 candela/m$^2$ respectively. The average luminance and peak luminance of the yellow phosphor was 1171 candela/m$^2$ and 3031 candela/m$^2$ respectively. The average luminance and peak luminance of the orange-red phosphor was 578 candela/m$^2$ and 1095 candela/m$^2$ respectively.

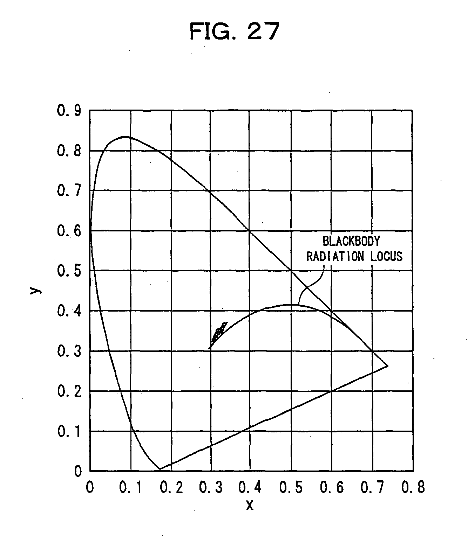

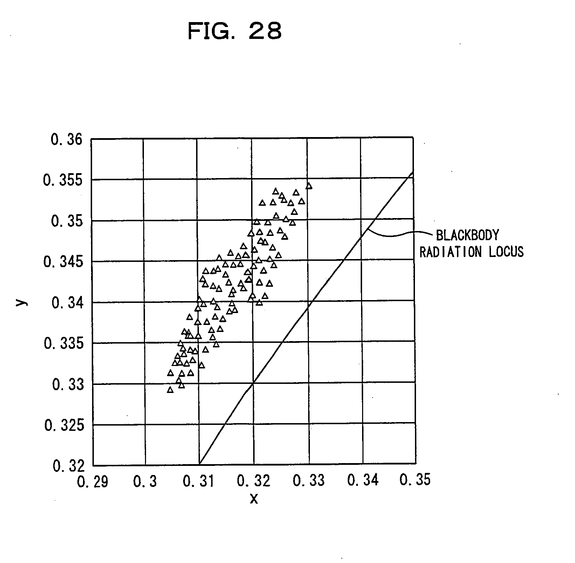

A sheet of white paper is positioned, as the irradiated surface, at the distance of 25 cm from the light source. Then the white paper is irradiated with the synthesized light from the above-mentioned light source. The CIE chromaticity coordinates were measured in arbitral points on a square with the size of 20 cm x 20 cm, which was a selected one part of the white paper. Fig. 27 is a drawing of the CIE chromaticity coordinates measured, plotted on the CIE chromaticity diagram. Fig. 28 is an enlarged drawing in the vicinity of the plots of Fig. 27. As shown in Figs. 27 and 28, the color of the synthesized light was white at each location. In addition, all the difference between their CIE chromaticity coordinates were within the range of 0.05. From this result, it was confirmed that the synthesized light was homogenized at the irradiated surface, due to the equalized illuminance distribution characteristics.

In this measurement, general color rendering index Ra showed 80, and the luminous efficiency showed 2.422 lm/W. At this point, near-UV LED used was a manufacture referred to as "E1S19-OPOA07-02", of which typical external quantum efficiency is 3.333 % and minimum external quantum efficiency is 1.212 % according to reference values on a spec sheet. However, a high-efficiency near-UV LED with LEPS structure, developed in recent years, is said to have external quantum efficiency of 40 %, according to Non-Patent Document 4. Therefore, by replacing the commercially available near-UV LED by LEPS-LED, the value will be expected to take either value of 79.94 to 29.069 lm/W, by reverse calculation. In the present Example, all components were selected from commercially available ones, so that anyone can carry out a check experiment for testing the mixed illuminance distribution.

[Comparative Example 2]

A light source was produced in cluster shape from three wavelengths of LEDs, which was usual, commercially available AlInGaP red LED, InGaN green LED and InGaN blue LED, and the measurement for it was carried out. The LEDs, having emission surfaces with the diameter of 5 mm and capable of emitting red, green or blue primary light respectively, were used as primary light sources. These LEDs were set to be located at each apex of an equilateral triangle on a plane. The distance between each center of the primary light sources and the center of the above-mentioned equilateral triangle was set to measure 0.6928 mm.

In addition, the CIE chromaticity coordinates of the primary lights emitted from each primary light source are as follows. It is (0.702,0.300) in red LED, (0.169,0.718) in green LED, and (0.124,0.083) in blue LED.

The light intensity of each primary light source in $\theta$ direction was measured, at every 30 degrees of $\Phi$. Thereby it was confirmed that the symmetry, around the axis of $\Phi$, of the illuminance distribution of the light intensity of each primary light source was collapsed. This affirmed that each primary light source has a strain distribution of light, and the illuminance distribution characteristics of the light source produced in the present Comparative Example were not equalized.

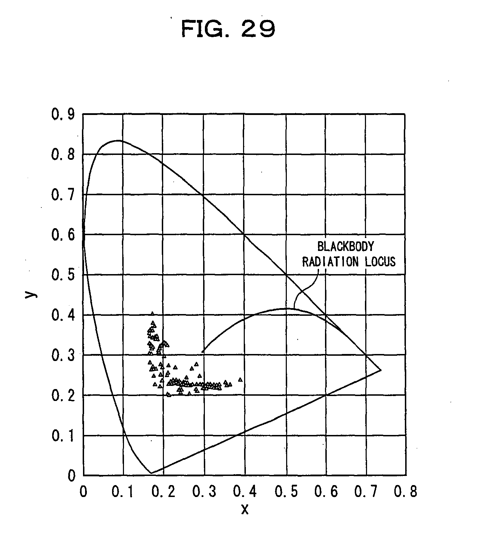

A sheet of white paper was positioned, as the irradiated surface, at the distance of 45 cm from the light source. Then the white paper is irradiated with the synthesized light from the above-mentioned light source. The CIE chromaticity coordinates were measured in arbitral points on a square with the size of 20 cm x 20 cm, which was a selected one part of the white paper. Fig. 29 is a drawing of the CIE chromaticity coordinates measured, plotted on the CIE chromaticity diagram.

As shown in Fig. 29, when the illuminance distribution characteristics are not set to be equalized, the synthesized light can not be homogenized at the irradiated surface, and the color thereof shows different at each observation point.

The value of general color rendering index in this example does not exist, because the color is not in the vicinity of white and therefore the value can not be calculated.

Furthermore, an extraordinary separation of colors was observed, as shown in Fig. 29. The light source of the present Comparative Example therefore is difficult to be used for a lighting system.

Industrial Applicability

The present invention can be widely used in any fields of industry. For example, it can be preferably used as lighting system, display, character display and backlight for liquid crystal display.

The present invention has been explained in detail above with reference to specific embodiments. However, it is evident to those skilled in the art that various modifications can be added thereto without departing from the intention and the scope of the present invention.

The present application is based on the descriptions of Japanese Patent Application No. 2005-36688, filed on February 14, 2005, and Japanese Patent Application No. 2006-34870, filed on February 13, 2006, and their entireties are incorporated herewith by reference.

**Claims**

1. A light source comprising two or more primary light sources, each of which emits primary light having different wavelength, for emitting synthesized light which is synthesized from the primary lights emitted from said primary light sources, wherein
   the maximum value among differences between each of CIE chromaticity coordinates of the primary lights is 0.05 or larger,
   the primary lights have the same illuminance distribution characteristics to the extent that the color of the synthesized light is homogenized at a desired irradiated surface,
   the luminous efficiency is 30 lm/W or larger, and

the general color rendering index is 60 or larger.

2. A light source as defined in claim 1, wherein each of said two or more primary light sources comprises a light-emitting solid device emitting light having different wavelength from each other.

3. A light source as defined in claim 1, wherein at least one of said two or more primary light sources comprises a light-emitting solid device and a phosphor section including a phosphor absorbing light from the light-emitting solid device and emitting light.

4. A light source as defined in any one of claims 1 to 3, wherein a spread angle of the primary lights emitted from said primary light sources is between 5° and 180° inclusive.

5. A light source as defined in any one of claims 1 to 4, wherein each of said primary light sources comprises a illuminance-distribution controlling element.

6. A light source as defined in claim 5, wherein the illuminance-distribution controlling element has the capability of collecting the primary lights.

7. A light source as defined in any one of claims 1 to 6, wherein the color of the synthesized light is white, when observed from a distance of at least 2.5 m.

8. A light-emitting solid device module for constituting said light source as defined in claim 2 or 3, comprising:

   a base; and
   the light-emitting solid device disposed on said base.

9. A phosphor module for constituting said light source as defined in claim 3, comprising:

   a base; and
   the phosphor section disposed on said base.

10. A illuminance-distribution element module for constituting said light source as defined in claim 5 or 6, comprising:

    a base; and
    the illuminance-distribution controlling element disposed on said base.

11. A light source comprising two or more primary light sources, each of which emits primary light having different wavelength, for emitting synthesized light which is synthesized from the primary lights emitted from said primary light sources, wherein
    the maximum value among differences between each of CIE chromaticity coordinates of the primary lights is 0.05 or larger, and
    the primary lights have the same illuminance-distribution characteristics to the extent that the color of the synthesized light is homogenized at a desired irradiated surface, and
    said light source further comprising:

    a primary-light controller capable of controlling at least a part of the amount of the primary lights by controlling said primary light sources.

12. A light source as defined in claim 11, wherein at least one of said primary light sources comprises a light-emitting solid device, and
    the primary-light controller controls the amount of light emitted from the light-emitting solid device.

13. A lighting system comprising a light source as defined in any one of claims 1 to 7, 11, and 12.

14. A display comprising a light source as defined in any one of claims 1 to 7, 11, and 12.

15. A method for controlling light emitted from a light source comprising two or more primary light sources, each of which emits primary light having different wavelength, for emitting synthesized light which is synthesized from the primary lights emitted from said primary light sources, comprising the step of:

replacing said primary light source in a manner that the maximum value among differences between each of CIE chromaticity coordinates of the primary lights is kept to be 0.05 or larger and the primary lights are kept to have the same illuminance distribution characteristics to the extent that the color of the synthesized light is homogenized at a desired irradiated surface.

16. A method for controlling light emitted from a light source comprising two or more primary light sources, each of which comprises light-emitting solid device and emits primary light having different wavelength, for emitting synthesized light which is synthesized from the primary lights emitted from said primary light sources, comprising the step of:

controlling the amount of the primary lights in a manner that the maximum value among differences between each of CIE chromaticity coordinates of the primary lights is kept to be 0.05 or larger and the primary lights are kept to have the same illuminance distribution characteristics to the extent that the color of the synthesized light is homogenized at a desired irradiated surface.

## FIG. 1

OPTICAL AXIS

θ AXIS

φ AXIS

PRIMARY LIGHT SOURCE

## FIG. 2

22

21

4

2

1

# FIG. 3

# FIG. 4

## FIG. 5

## FIG. 6

## FIG. 7

SUPPLIED POWER CONTROLLER —91

ELECTRIC ENERGY MEMORY UNIT —92

## FIG. 8

## FIG. 9

RED MULTIPOINT
LIGHT SOURCE

GREEN MULTIPOINT
LIGHT SOURCE

BLUE MULTIPOINT
LIGHT SOURCE

Z[cm]

θ

IRRADIATED SURFACE

## FIG. 10

FIG. 11

20 [cm]

Z = 10 [cm]

FIG. 12

Z=10[cm]

FIG. 13

500 [cm]

Z = 250 [cm]

## FIG. 14

BLACKBODY
RADIATION LOCUS

Z=250[cm]

FIG. 15

20 [cm]

Z = 10 [cm]

# FIG. 16

Z=10[cm]

# FIG. 17

500 [cm]

Z = 250 [cm]

## FIG. 18

BLACKBODY
RADIATION LOCUS

X

Z=250 [cm]

FIG. 19

20 [cm]

Z = 10 [cm]

## FIG. 20

BLACKBODY
RADIATION LOCUS

Z=10[cm]

FIG. 21

500 [cm]

Z = 250 [cm]

FIG. 22

BLACKBODY
RADIATION LOCUS

Z=250 [cm]

FIG. 23

20 [cm]

Z = 10 [cm]

FIG. 24

Z=10[cm]

FIG. 25

500 [cm]

Z = 250 [cm]

## FIG. 26

Z=250[cm]

## FIG. 27

# FIG. 28

## FIG. 29

# INTERNATIONAL SEARCH REPORT

| International application No. |
|---|
| PCT/JP2006/302901 |

A. CLASSIFICATION OF SUBJECT MATTER
**F21V3/04**(2006.01), **F21S2/00**(2006.01), **F21S8/04**(2006.01), **F21V5/04**(2006.01), **F21V9/08**(2006.01), *F21Y101/02*(2006.01)

According to International Patent Classification (IPC) or to both national classification and IPC

B. FIELDS SEARCHED

Minimum documentation searched (classification system followed by classification symbols)
F21S2/00, F21S8/04, F21V3/04, F21V5/04, F21V9/08, F21Y101/02

Documentation searched other than minimum documentation to the extent that such documents are included in the fields searched
Jitsuyo Shinan Koho          1922-1996     Jitsuyo Shinan Toroku Koho    1996-2006
Kokai Jitsuyo Shinan Koho    1971-2006     Toroku Jitsuyo Shinan Koho    1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-188002 A (Toyoda Gosei Co., Ltd.), 04 July, 2000 (04.07.00), Full text; all drawings (Family: none) | 1-16 |
| Y | JP 7-38154 A (Sharp Corp.), 07 February, 1995 (07.02.95), Par. No. [0020] (Family: none) | 1-16 |
| Y | JP 2002-52836 A (Koninklijke Philips Electronics N.V.), 13 August, 2002 (13.08.02), Claims 3, 4 & US 6234645 B          & EP 1047904 A & WO 00/19141 A1          & CN 1289397 A | 1-10 |

| ☒ Further documents are listed in the continuation of Box C. | ☐ See patent family annex. |
|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 May, 2006 (17.05.06) | 23 May, 2006 (23.05.06) |

| Name and mailing address of the ISA/ Japanese Patent Office | Authorized officer |
|---|---|
| Facsimile No. | Telephone No. |

Form PCT/ISA/210 (second sheet) (April 2005)

**INTERNATIONAL SEARCH REPORT**

International application No.

PCT/JP2006/302901

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-349646 A (Matsushita Electric Works, Ltd.), 09 December, 2004 (09.12.04), Full text; all drawings (Family: none) | 9,10 |
| Y | JP 2000-150089 A (Kabushiki Kaisha Mashiro), 30 May, 2000 (30.05.00), (Family: none) | 15 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004071726 A
- JP 2004300247 A
- JP 2005036688 A
- JP 2006034870 A

### Non-patent literature cited in the description

- Lighting handbook. 73-80102-116
- Lighting handbook. 126-129
- Technology for High-Brightness, High-Efficiency, and Prolonged-Life White-Light LED Lighting Systems. Technical Information Institute Co., Ltd, 90-93
- **T.TAGUCHI.** Present Status of White Lighting Technologies in Japan. *J.Light & Vis. Env.,* 2003, vol. 27 (3), 131-139
- NHK Color TV Textbook. Japan Broadcasting Corporation, vol. 1, 2
- **HEIJU UCHIIKE ; SHIGEO MIKOSHIBA.** All about Plasma Display TV
- Lighting handbook. 139-144
- **NORIO KOJIMA.** Basis of Pulse and Digital Circuit